# EUROPEAN PATENT APPLICATION

(11) **EP 1 953 595 A1**
(43) Date of publication of application: **06.08.2008**
(21) Application number: 06823478.0
(22) Date of filing: 20.11.2006
(51) Int. Cl.: G03F 7/039, G03F 7/20, H01L 21/027

(54) **RADIATION-SENSITIVE RESIN COMPOSITION**

(30) Priority: 21.11.2005 JP 2005335848
(71) Applicant: JSR Corporation, Tokyo 104-8410 (JP)
(72) Inventor: NAKAMURA, Atsushi, Tokyo 104-8410 (JP); WANG, Yong, Tokyo 104-8410 (JP); TSUJI, Takayuki, Tokyo 104-8410 (JP)
(74) Representative: TBK-Patent
(86) International application number: PCT/JP2006/323091
(87) International publication number: WO 2007/058345

(57) **Abstract**

A radiation-sensitive resin composition for liquid immersion lithography which produces an excellent pattern profile, exhibits excellent resolution, provides sufficient focal depth allowance, and elutes only the minimal amount in the liquid when brought in contact with the liquid during exposure to radiation. The radiation-sensitive resin composition forms a photoresist film in liquid immersion lithography, in which radiation is emitted through a liquid for use in liquid immersion lithography having a refractive index larger than 1.44 and smaller than 1.85 at a wavelength of 193 nm, existing between a lens and a photoresist, the composition comprising a resin having a recurring unit with a lactone structure, which is insoluble or scarcely soluble in alkali, but becomes soluble in alkali by the action of an acid, and a radiation-sensitive acid generator.

## Description

### TECHNICAL FIELD

The present invention relates to a radiation-sensitive resin composition used for liquid immersion lithography. More particularly, the present invention relates to a radiation-sensitive resin composition for liquid immersion lithography which produces an excellent pattern profile, exhibits excellent resolution, provides sufficient focal depth allowance, and elutes only the minimal amount in the liquid used for liquid immersion lithography when brought in contact with the liquid during exposure to radiation.

### BACKGROUND ART

In the field of microfabrication represented by fabrication of integrated circuit devices, lithographic technology enabling microfabrication with a line width of about 200 nm or less has been demanded in recent years in order to achieve a higher degree of integration. However, microfabrication in a subquarter micron level is said to be very difficult using near ultraviolet rays such as i-lines which are generally used as radiation in a common lithography process. Therefore, use of radiation with a shorter wavelength has been studied for enabling microfabrication at a 200 nm or less level. As examples of such short wavelength radiation, bright line spectrum of a mercury lamp, deep ultraviolet rays represented by excimer lasers, X rays, electron beams, and the like can be given. A KrF excimer laser (wavelength: 248 nm) or an ArF excimer laser (wavelength: 193 nm) are given particular attention.

As a resist suitable for being irradiated with such an excimer laser, many resists (hereinafter referred to as a chemically amplified resists) utilizing the chemical amplification effect of a component having an acid-dissociable functional group and a component which generates acid (hereinafter referred to as "an acid generator") by irradiation (hereinafter referred to as "exposure") have been proposed. As a chemically amplified resist, a resist containing a resin having a t-butyl ester group of carboxylic acid or a t-butyl carbonate group of phenol and an acid generator has been proposed. The t-butyl ester group or t-butyl carbonate group in the resin dissociates by the action of an acid generated upon exposure, whereby the resin has an acidic group such as a carboxylic group or a phenolic hydroxyl group. As a result, exposed areas of the resist film become readily soluble in an alkaline developer.

Capability of forming more minute patterns (a minute resist pattern with a line width of about 90 nm, for example) will be required for such a lithography process in the future. Reducing the wavelength of light source of a photolithography machine and increasing the numerical aperture (NA) of a lens can be a method of forming such a pattern with a line width of less than 90 nm. However, an expensive exposure machine is necessary for reducing the wavelength of a light source. In addition, increasing the numerical aperture (NA) of a lens involves a problem of decreasing the depth of focus even if resolution is increased due to a trade-off relationship between the resolution and the depth of focus.

Recently, a liquid immersion lithographic method has been reported as a lithographic technique enabling solution of such a problem. In this method, a layer of pure water or a liquid refractive index medium (an immersion solution) is used between the lens and the resist film on a substrate, at least on the surface of the resist film. According to this method, an inert gas atmosphere in the light-path, such as air or nitrogen, is replaced by a liquid with a larger refractive index (n), for example, pure water, whereby the resolution can be increased without a decrease in focal depth by using a light source with a given wavelength to the same degree as in the case in which a light source with a shorter wavelength is used, or the case in which a higher NA lens is used. Since a resist pattern with a higher resolution excelling in focal depth can be formed at a low cost using the lens mounted in existing apparatuses by using the liquid immersion lithographic method, this method has received a great deal of attention.

In the liquid immersion lithographic process, however, since the resist film is brought into direct contact with a refractive-index liquid (immersion solution) such as pure water during exposure, an acid generator or the like is eluted from the resist film. When the amount of eluted components is large, a desired pattern profile and sufficient resolution may not be obtained, and the lens may be polluted.

In order to avoid such problems, resins for use with the resist for liquid immersion lithography have been proposed in Patent Document 1 and Patent Document 2.

However, resists made from these resins do not always produce a satisfactory pattern profile or exhibit excellent resolution.
[Patent Document 1] WO 2004/068242
[Patent document 2] Japanese Patent Application Laid-open No. 2005-173474

### DISCLOSURE OF THE INVENTION

### Problems to be Solved by the Invention

An object of the present invention is to provide a radiation-sensitive resin composition for liquid immersion lithography which can produce excellent pattern profile, exhibits excellent resolution, and elutes the minimal amount of components in a liquid used for liquid immersion lithography during exposure in the liquid.

### Means for Solving the Problems

The radiation-sensitive resin composition of the present invention forms a photoresist film used in liquid immersion lithography, in which radiation is emitted through a liquid for use in liquid immersion lithography having a refractive index larger than 1.44 and smaller than 1.85 at a wavelength of 193 nm, existing between a lens and a photoresist film, and the radiation-sensitive resin composition comprises a resin having a recurring unit with a lactone structure, which is insoluble or scarcely soluble in alkali, but becomes soluble in alkali by the action of an acid, and a radiation-sensitive acid generator.

In the above radiation-sensitive resin composition, the resin is a copolymer having a recurring unit with a lactone structure and a recurring unit shown by the following formula (1), 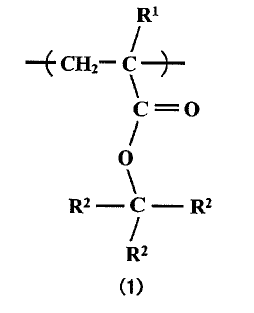 wherein R¹ represents a hydrogen atom, a methyl group, or a trifluoromethyl group, R² individually represents a monovalent alicyclic hydrocarbon group having 4 to 20 carbon atoms, a derivative thereof, or a linear or branched alkyl group having 1 to 4 carbon atoms, provided that at least one of the R²s is the alicyclic hydrocarbon group or a derivative thereof, or two of the R²s bond to form a divalent alicyclic hydrocarbon group having 4 to 20 carbon atoms or a derivative thereof, with the remaining R² being a linear or branched alkyl group having 1 to 4 carbon atoms, a monovalent alicyclic hydrocarbon group having 4 to 20 carbon atoms, or a derivative thereof.

In the copolymer having the recurring unit with a lactone structure and the recurring unit shown by the formula (1), the content of low molecular weight components containing monomers as the major component is not more than 0.1 wt%, on a solid basis, of the total amount of the copolymer.

The radiation-sensitive resin composition of the present invention is used for a liquid immersion lithographic process in which the liquid for liquid immersion lithography is preferably an alicyclic hydrocarbon compound and/or a chain-like saturated hydrocarbon compound.

### Effect of the Invention

Since the radiation-sensitive resin composition of the present invention contains a polymer having a recurring unit with a lactone structure as a resin component, the composition can produce an excellent pattern profile and exhibit excellent resolution and focal depth allowance even in a liquid immersion lithographic process in which light is emitted through a liquid for liquid immersion lithography having a refractive index of more than 1.44 and less than 1.85 at a wavelength of 193 nm. In addition, the radiation-sensitive resin composition elutes only a minimal amount of components in the liquid for liquid immersion lithography, even when the liquid is a hydrocarbon with a high refractive index.

### BEST MODE FOR CARRYING OUT THE INVENTION

As the recurring unit having a lactone structure of the resin of the present invention, units shown by the following formulas (2-1) to (2-6) can be given. These recurring units may be used either individually or in combination of two or more. 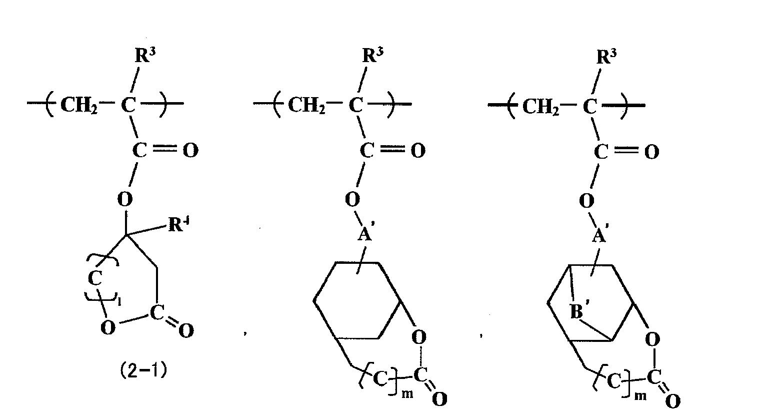 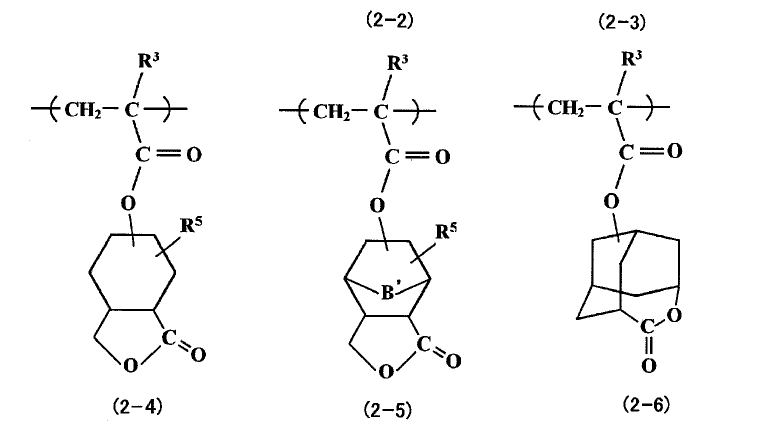 wherein R³ represents a hydrogen atom or a methyl group, R⁴ represents a hydrogen atom or a substituted or unsubstituted alkyl group having 1 to 4 carbon atoms, R⁵ represents a hydrogen atom or a methoxy group, A' represents a single bond or a methylene group, B' represents an oxygen atom or a methylene group, 1 is an integer of 1 to 3, and m is 0 or 1.

The formula (2-3) is preferable among the formulas (2-1) to (2-6). In the formula (2-3), B' is preferably a methylene group and m is preferably 0 or 1.

The content of the recurring units with a lactone structure in a copolyler is preferably 5 to 85 mol%, more preferably 10 to 70 mol%, and particularly preferably 15 to 60 mol% of the total amount of the copolymer. If the content of the recurring units is less than 5 mol%, developability and exposure allowance (focal depth allowance) tend to decrease, and if the content is more than 85 mol%, solubility of the copolymer in a solvent and resolution tend to decrease.

A recurring unit having an acid-dissociable group at a side chain shown by the above formula (1) may be used with the recurring unist having the lactone structure.

In the formula (1), R¹ represents a hydrogen atom, a methyl group, or a trifluoromethyl group, R² individually represents a monovalent alicyclic hydrocarbon group having 4 to 20 carbon atoms, a derivative thereof, or a linear or branched alkyl group having 1 to 4 carbon atoms, provided that at least one of the R²s is an alicyclic hydrocarbon group or a derivative thereof, or two of the R²s form a divalent alicyclic hydrocarbon group having 4 to 20 carbon atoms or a derivative thereof with the hydrogen atom to which the R²s bond, with the remaining R² being a linear or branched alkyl group having 1 to 4 carbon atoms, a monovalent alicyclic hydrocarbon group having 4 to 20 carbon atoms, or a derivative thereof.

As examples of the linear or branched alkyl group having 1 to 4 carbon atoms represented by R², a methyl group, an ethyl group, an n-propyl group, an i-propyl group, an n-butyl group, a 2-methylpropyl group, a 1-methylpropyl group, a t-butyl group, and the like can be given. Of these alkyl groups, a methyl group and an ethyl group are preferable.

As examples of the skeleton of -C(R²)₃ part in the -COOC(R²)₃ in the formula (1), groups shown by the following formulas (1a), (1b), (1c), (1d), (1e), and (1f) can be given. 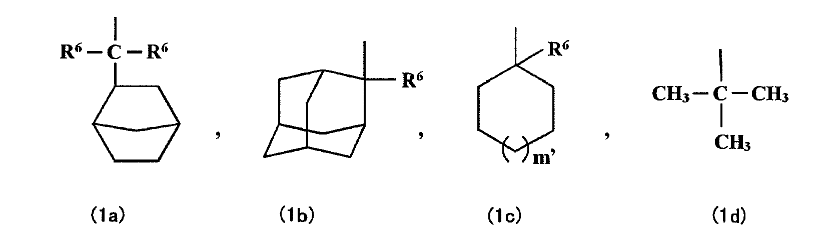 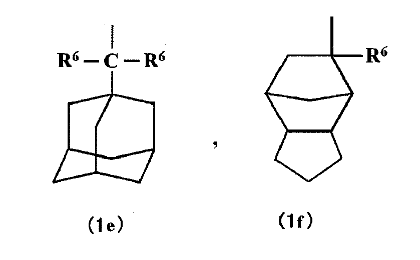 wherein R⁶ individually represents a linear or branched alkyl group having 1 to 4 carbon atoms, and m' is 0 or 1. As examples of the linear or branched alkyl group having 1 to 4 carbon atoms, a methyl group, an ethyl group, an n-propyl group, an i-propyl group, an n-butyl group, a 2-methylpropyl group, a 1-methylpropyl group, a t-butyl group, and the like can be given. Of these alkyl groups, a methyl group and an ethyl group are preferable.

The -COOC(R²)₃ in the formula (1) dissociates by the action of an acid and forms a carboxyl group to become an alkali-soluble part. The term "alkali-soluble part" refers to an (alkali-soluble) group which becomes anion by the action of an alkali. The term "acid-dissociable group" refers to a group in which the alkali-soluble part is protected by a blocking group and is not alkali-soluble until the blocking group is dissociated by an acid. The copolymer of the present invention becomes a resin which is easily soluble in alkali by the action of an alkali from a resin which is insoluble or scarcely soluble in alkali due to the possession of the recurring unit of the formula (1). The term "insoluble or scarcely soluble in alkali" refers to properties in which the initial thickness of a film formed only with the copolymer of the present invention remains in an amount of 50% or more after development under alkaline conditions employed when forming a resist pattern using a resist film formed from a radiation-sensitive resin composition containing the copolymer of the present invention. The term "easily soluble in alkali" means the characteristics in which 50% or more of the initial film thickness of a resist film is lost.

The content of the recurring unit shown by the formula (1) in the copolyler is preferably 10 to 70 mol%, more preferably 20 to 60 mol%, and particularly preferably 20 to 50 mol% of the total amount of the copolymer. If the content is less than 10 mol%, resolution as a resist tends to decrease. If the content exceeds 70 mol%, exposure allowance tends to decrease. The term "exposure allowance" indicates fluctuation of the line width to the change of the exposure amount.

The copolymer of the resin component of the present invention may have a recurring unit other than the recurring unit with a lactone structure and the recurring unit shown by the formula (1). As examples of the other recurring unit, a recurring unit produced by cleavage of a polymerizable unsaturated bond of a monofunctional or a polyfunctional monomer such as carboxyl group-containing acrylates such as 2-carboxyethyl (meth)acrylate, 2-carboxy-n-propyl (meth)acrylate, 3-carboxy-n-propyl (meth)acrylate, 4-carboxy-n-butyl (meth)acrylate, and 4-carboxycyclohexyl (meth)acrylate; unsaturated nitrile compounds such as (meth)acrylonitrile, α-chloroacrylonitrile, crotonitrile, maleinitrile, fumaronitrile, mesaconitrile, citraconitrile, and itaconitrile; unsaturated amide compounds such as (meth)acrylamide, N,N-dimethyl(meth)acrylamide, crotonamide, maleinamide, fumaramide, mesaconamide, citraconamide, and itaconamide; nitrogen-containing vinyl compounds such as N-(meth)acryloylmorpholine, N-vinyl-ε-caprolactam, N-vinylpyrrolidone, vinylpyridine, and vinylimidazole; unsaturated carboxylic acids (anhydrides) such as (meth)acrylic acid, crotonic acid, maleic acid, maleic anhydride, fumaric acid, itaconic acid, itaconic anhydride, citraconic acid, citraconic anhydride, and mesaconic acid; polyfunctional monomers such as polyfunctional (meth)acrylic acid esters having a bridged hydrocarbon skeleton such as 1,2-adamantanediol di(meth)acrylate, 1,3-adamantanediol di(meth)acrylate, 1,4-adamantanediol di(meth)acrylate, and tricyclodecanyldimethylol di(meth)acrylate; (meth)acrylic acid esters having no bridged hydrocarbon skeleton such as methyleneglycol di(meth)acrylate, ethyleneglycol di(meth)acrylate, propyleneglycol di(meth)acrylate, 1,6-hexanediol di(meth)acrylate, 2,5-dimethyl-2,5-hexanediol di(meth) acrylate, 1,8-octanediol di(meth)acrylate, and 1,9-nonanediol di(meth)acrylate; and recurring units shown by the following formulas (3) to (7) can be given. These recurring units can be used either individually or in combination of two or more. 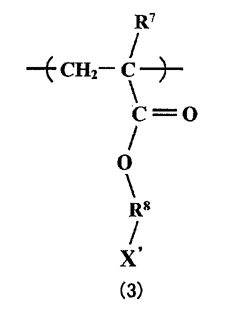 wherein R⁷ represents a hydrogen atom, a methyl group, a trifluoromethyl group, or a hydroxymethyl group, and R⁸ indicates a linear or branched alkylene group having 1 to 4 carbon atoms or an alicyclic alkylene group having 3 to 20 carbon atoms. As examples of the linear or branched alkylene group having 1 to 4 carbon atoms, a methylene group, an ethylene group, an n-propylene group, an i-propylene group, an n-butylene group, a 2-methylpropylene group, a 1-methylpropylene group, and a t-butylene group can be given. As examples of the alicyclic alkylene group having 3 to 20 carbon atoms, a cycloalkylene group represented by -CₙH₂ₙ₋₂- (wherein n is an integer of 3 to 20) such as a cyclopropylene group, a cyclobutylene group, a cyclopentylene group, a cyclohexylene group, a cycloheptylene group, and a cyclooctylene group, and a polycyclic alkylene group such as a bicyclo[2.2.1]heptylene group, a tricyclo[5.2.1.0^{2,6}]decylene group, a tricyclo[6.2.1^{3,6}.0^{2,7}]dodecanylene group, an adamantly group, and the like can be given. X' represents a hydrogen atom, a hydroxyl group, a cyano group, or a hydroxyalkyl group having 1 to 10 carbon atoms. 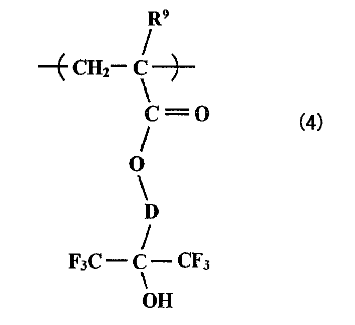 wherein R⁹ represents a hydrogen atom, a methyl group, a trifluoromethyl group, or a hydroxymethyl group, and D indicates a single bond, a linear or branched alkylene group having 1 to 6 carbon atoms, an alicyclic hydrocarbon group having 4 to 20 carbon atoms, an alkylene glycol group, or an alkylene ester group. As examples of the linear or branched alkylene groups having 1 to 6 carbon atoms, a methylene group, an ethylene group, a propylene group, a butylene group, a pentylene group, a hexylene group, a cyclohexylene group, and the like can be given. 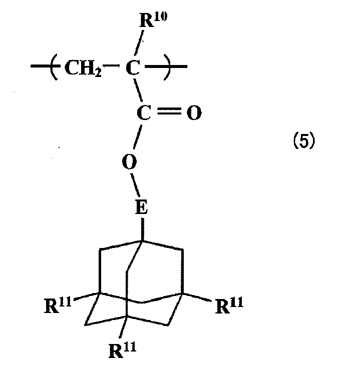 wherein R¹⁰ represents a hydrogen atom, a methyl group, a trifluoromethyl group, or a hydroxymethyl group, and E indicates a single bond or a divalent alkylene group having 1 to 3 carbon atoms. R¹¹ individually represents a hydroxyl group, a cyano group, a carboxyl group, -COOR¹⁴, or -M'-R¹⁵, wherein R¹⁴ represents a hydrogen atom, a linear or a branched alkyl group having 1 to 4 carbon atoms, or an alicyclic alkyl group having 3 to 20 carbon atoms, M' individually represents a single bond or a divalent alkylene group having 1 to 3 carbon atoms, and R¹⁵ individually represents a hydrogen atom, a hydroxyl group, a cyano group, or -COOR¹⁶ group, provided that at least one R¹¹ group is not a hydrogen atom. A single bond, a methylene group, an ethylene group, and a propylene group can be given as E and M'. R¹⁶ in the -COOR¹⁶ group represents a hydrogen atom, a linear or branched alkyl group having 1 to 4 carbon atoms, or an alicyclic alkyl group having 3 to 20 carbon atoms. As examples of the linear or branched alkyl group having 1 to 4 carbon atoms, a methyl group, an ethyl group, an n-propyl group, an i-propyl group, an n-butyl group, a 2-methylpropyl group, a 1-methylpropyl group, and a t-butyl group can be given. As examples of the alicyclic alkyl group having 3 to 20 carbon atoms, a cycloalkyl group represented by -CₙH₂ₙ₋₁ (wherein n is an integer of 3 to 20) such as a cyclopropyl group, a cyclobutyl group, a cyclopentyl group, a cyclohexyl group, a cycloheptyl group, and a cyclooctyl group, a polycyclic alkyl group such as a bicyclo[2.2.1]heptyl group, a tricyclo[5.2.1.0^{2,6}]decyl group, a tricyclo[6.2.1^{3,6}.0^{2,7}]dodecanyl group, and an adamantly group, a group in which the cycloalkyl group or polycyclic alkyl group is substituted with one or more linear, branched, or cyclic alkyl groups, and the like can be given. 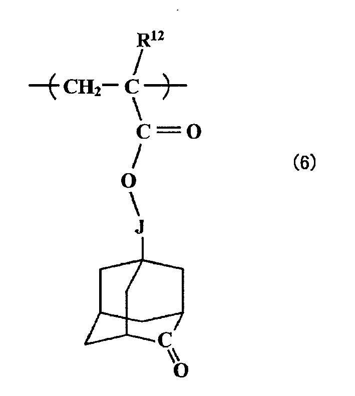 wherein R¹² represents a hydrogen atom, a methyl group, a trifluoromethyl group, or a hydroxymethyl group, and J indicates a single bond, a substituted or unsubstituted linear, branched, or cyclic alkylene group, alkylene glycol group, or alkylene ester group having 1 to 20 carbon atoms. 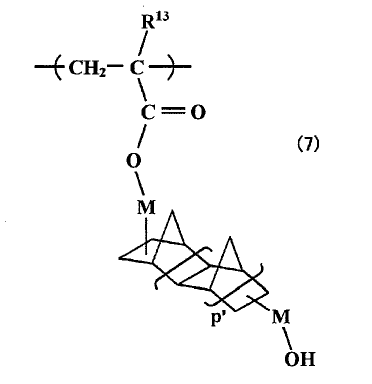 wherein R¹³ represents a hydrogen atom, a methyl group, a trifluoromethyl group, or a hydroxymethyl group, and M individually represents a single bond, a substituted or unsubstituted linear, branched, or cyclic alkylene group, alkylene glycol group, or alkylene ester group having 1 to 20 carbon atoms. As examples of the linear or branched alkylene groups, a methylene group, an ethylene group, a propylene group, a butylene group, a pentylene group, a hexylene group, and a cyclohexylene group can be given. p' is 0 or 1.

The total content of "the other recurring units" in the copolymer is appropriately adjusted according to the use and the like of the copolymer. Such a content in the case of the radiation-sensitive resin composition hereinafter described is preferably 0.1 to 50 mol%, more preferably 0.1 to 40 mol%, and particularly preferably 0.1 to 30 mol% of the total amount of the copolymer. If the content exceeds 50 mol%, the effect of the lactone structure and the formula (1) may decrease.

The polystyrene-reduced weight average molecular weight of the copolymer of the resin component determined by gel permeation chromatography (GPC) (hereinafter referred to as "Mw") is 1,000 to 500,000, preferably 1,000 to 100,000, and more preferably 1,000 to 50,000. If the Mw of the copolymer is less than 1,000, heat resistance as a resist may be decreased. If the Mw exceeds 500,000, developability as a resist may be decreased. The ratio of the Mw to the polystyrene-reduced number average molecular weight (hereinafter called "Mn") (Mw/Mn) determined by GPC of the copolymer is preferably 1 to 5, and more preferably 1 to 3.

The content of low molecular weight components containing monomers as the major component in the copolymer is not more than 0.1 wt%, on a solid basis, of the total amount of the copolymer. The content of low molecular weight components may be measured by high performance liquid chromatography (HPLC), for example.

A method for manufacturing the copolymer is described below. Although not particularly limited, the method comprises polymerizing the polymerizable unsaturated monomers corresponding to the recurring units forming a desired molecular composition in an appropriate solvent in the presence of a chain transfer agent, as required, using a radical polymerization initiator such as a hydroperoxide, dialkyl peroxide, diacyl peroxide, or azo compound, for example.

As the solvent used for the polymerization, alkanes such as n-pentane, n-hexane, n-heptane, n-octane, n-nonane, and n-decane; cycloalkanes such as cyclohexane, cycloheptane, cyclooctane, decalin, and norbornane; aromatic hydrocarbons such as benzene, toluene, xylene, ethylbenzene, and cumene; halogenated hydrocarbons such as chlorobutanes, bromohexanes, dichloroethanes, hexamethylene dibromide, and chlorobenzene; saturated carboxylic acid esters such as ethyl acetate, n-butyl acetate, i-butyl acetate, and methyl propionate; ethers such as tetrahydrofuran, dimethoxyethanes, and diethoxyethanes; alcohols such as methanol, ethanol, 1-propanol, 2-propanol, 1-butanol, 2-butanol, isobutanol, 1-pentanol, 3-pentanol, 4-methyl-2-pentanol, o-chlorophenol, and 2-(1-methylpropyl)phenol; ketones such as acetone, 2-butanone, 3-methyl-2-butanone, 4-methyl-2-pentanone, 2-heptanone, cyclopentanone, cyclohexanone, methylcyclohexanone; and the like can be given. These solvents may be used either individually or in combination of two or more.

The polymerization temperature is usually from 40 to 150°C, and preferably from 50 to 120°C. The reaction time is usually from 1 to 48 hours, and preferably from 1 to 24 hours.

It is preferable that the copolymer contain almost no impurities such as halogens and metals. The smaller the amount of impurities, the better the sensitivity, resolution, process stability, and pattern profile of the resist. The copolymer can be purified using, for example, a chemical purification method such as washing with water or liquid-liquid extraction or a combination of the chemical purification method and a physical purification method such as ultrafiltration or centrifugation.

In addition to the above-mentioned copolymer of the present invention, the radiation sensitive resin composition of the present invention comprises a photoacid generator, an acid diffusion controller, and a solvent. The radiation-sensitive resin composition of the present invention which comprises the copolymer of the present invention is suitable for liquid immersion lithography in which radiation is emitted in a liquid immersion fluid having a refractive index at a wavelength of 193 nm of greater than 1.44 and less than 1.85 between a lens and a photoresist film. In addition, the radiation-sensitive resin composition has excellent basic properties as a chemically-amplified resist such as sensitivity, resolution, and depth of focus.

The photoacid generator which may be used in the radiation-sensitive resin composition of the present invention is a radiation-sensitive acid generator which generates an acid upon exposure (hereinafter simply referred to as "acid generator"). The acid generator causes an acid-dissociable group in the recurring unit shown by the formula (1) in the copolymer to dissociate (disconnect a blocking group) by the action of the acid generated upon exposure. As a result, an exposed part of the resist film becomes readily soluble in an alkaline developer, thereby forming a positive-tone resist pattern. In the present invention, the acid generator preferably contains a compound shown by the following formula (8) (hereinafter called "acid generator 1"). 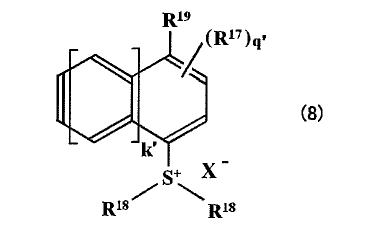 wherein R¹⁹ represents a hydrogen atom, a fluorine atom, a hydroxyl group, a linear or branched alkyl group having 1 to 10 carbon atoms, a linear or branched alkoxyl group having 1 to 10 carbon atoms, or a linear or branched alkoxycarbonyl group having 2 to 11 carbon atoms, R¹⁷ represents a linear or branched alkyl group or alkoxyl group having 1 to 10 carbon atoms, or a linear, branched or cyclic alkanesulfonyl group having 1 to 10 carbon atoms, R¹⁸ individually represents a linear or branched alkyl group having 1 to 10 carbon atoms, a substituted or unsubstituted phenyl group, or a substituted or unsubstituted naphthyl group, or two R¹⁸ groups bond to form a substituted or unsubstituted divalent group having 2 to 10 carbon atoms, k' is an integer of 0 to 2, X⁻ represents an anion represented by the formula R²⁰CₙF₂ₙSO₃⁻ (wherein R²⁰ represents a fluorine atom or a substituted or unsubstituted hydrocarbon group having 1 to 12 carbon atoms, and n is an integer of 1 to 10), and q' is an integer of 0 to 10.

Examples of the linear or branched alkyl group having 1 to 10 carbon atoms for R¹⁷, R¹⁸, or R¹⁹ in the formula (8) include a methyl group, an ethyl group, an n-propyl group, an i-propyl group, an n-butyl group, a 2-methylpropyl group, a 1-methylpropyl group, a t-butyl group, an n-pentyl group, a neopentyl group, an n-hexyl group, an n-heptyl group, an n-octyl group, a 2-ethylhexyl group, an n-nonyl group, and an n-decyl group. Of these alkyl groups, a methyl group, an ethyl group, an n-butyl group, a t-butyl group, and the like are preferable.

As examples of the linear or branched alkoxyl group having 1 to 10 carbon atoms represented by R¹⁷ and R¹⁹, a methoxy group, an ethoxy group, an n-propoxy group, an i-propoxy group, an n-butoxy group, a 2-methylpropoxy group, a 1-methylpropoxy group, a t-butoxy group, an n-pentyloxy group, a neopentyloxy group, an n-hexyloxy group, an n-heptyloxy group, an n-octyloxy group, a 2-ethylhexyloxy group, an n-nonyloxy group, an n-decyloxy group, and the like can be given. Of these, a methoxy group, an ethoxy group, an n-propoxy group, and t-butoxy group are preferable.

As examples of the linear or branched alkoxycarbonyl group having 2 to 11 carbon atoms represented by R¹⁹, a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, an n-pentyloxycarbonyl group, a neopentyloxycarbonyl group, an n-hexyloxycarbonyl group, an n-heptyloxycarbonyl group, an n-octyloxycarbonyl group, a 2-ethylhexyloxycarbonyl group, an n-nonyloxycarbonyl group, an n-decyloxycarbonyl group, and the like can be given. Of these alkoxycarbonyl groups, a methoxycarbonyl group, an ethoxycarbonyl group, an n-butoxycarbonyl group, and the like are preferable.

As examples of the linear, branched, or cyclic alkanesulfonyl group having 1 to 10 carbon atoms represented by R¹⁷, a methanesulfonyl group, an ethanesulfonyl group, an n-propanesulfonyl group, an n-buthanesulfonyl group, a tert-butanesulfonyl group, an n-pentanesulfonyl group, a neopentanesulfonyl group, an n- hexanesulfonyl group, an n-heptanesulfonyl group, an n-octanesulfonyl group, a 2-ethylhexanesulfonyl group, an n-nonanesulfonyl group, an n-decanesulfonyl group, a cyclopentanesulfonyl group, and a cyclohexanesulfonyl group can be given. Of these alkanesulfonyl groups, a methanesylfonyl group, an ethanesulfonyl group, an n-propanesulfonyl group, an n-butanesulfonyl group, a cyclopentansulfonyl group, and a cyclohexanesulfonyl group are preferable.

q' is preferably 0 to 2.

As examples of the substituted or unsubstituted phenyl group represented by R¹⁸ in the formula (8), a phenyl group or a phenyl group substituted with a linear, branched, or cyclic alkyl group having 1 to 10 carbon atoms such as a phenyl group, an o-tolyl group, an m-tolyl group, a p-tolyl group, a 2,3-dimethylphenyl group, a 2,4-dimethylphenyl group, a 2,5-dimethylphenyl group; a 2,6-dimethylphenyl group, a 3,4-dimethylphenyl group, a 3,5-dimethylphenyl group, a 2,4,6-trimethylphenyl group, a 4-ethylphenyl group, a 4-t-butylphenyl group, a 4-cyclohexylphenyl group, and a 4-fluorophenyl group; a phenyl group or these alkyl-substituted phenyl groups further substituted with at least one group selected from a group consisting of a hydroxyl group, a carboxyl group, a cyano group, a nitro group, an alkoxyl group, an alkoxyalkyl group, an alkoxycarbonyl group, and an alkoxycarbonyloxy group; and the like can be given.

Examples of the alkoxyl group as the substituent for the phenyl group or alkyl-substituted phenyl group include linear, branched, or cyclic alkoxyl groups having 1 to 20 carbon atoms such as a methoxy group, an ethoxy group, an n-propoxy group, an i-propoxy group, an n-butoxy group, a 2-methylpropoxy group, a 1-methylpropoxy group, a t-butoxy group, a cyclopentyloxy group, and a cyclohexyloxy group.

Examples of the alkoxyalkyl group include linear, branched, or cyclic alkoxyalkyl groups having 2 to 21 carbon atoms such as a methoxymethyl group, an ethoxymethyl group, a 1-methoxyethyl group, a 2-methoxyethyl group, a 1-ethoxyethyl group, and a 2-ethoxyethyl group. Examples of the alkoxycarbonyl group include linear, branched, or cyclic alkoxycarbonyl groups having 2 to 21 carbon atoms such as a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, a cyclopentyloxycarbonyl group, and a cyclohexyloxycarbonyl group.

Examples of the alkoxycarbonyloxy group include linear, branched, or cyclic alkoxycarbonyloxy groups having 2 to 21 carbon atoms such as a methoxycarbonyloxy group, an ethoxycarbonyloxy group, an n-propoxycarbonyloxy group, an i-propoxycarbonyloxy group, an n-butoxycarbonyloxy group, a t-butoxycarbonyloxy group, a cyclopentyloxycarbonyl group, and a cyclohexyloxycarbonyl group. Preferable phenyl groups which may have a substituent represented by R¹⁸ in the formula (8) are a phenyl group, a 4-cyclohexylphenyl group, a 4-t-butylphenyl group, a 4-methoxyphenyl group, a 4-t-butoxyphenyl group, and the like.

As examples of the substituted or unsubstituted naphthyl group represented by R¹⁸, a naphthyl group or a naphthyl group substituted with a linear, branched, or cyclic alkyl group having 1 to 10 carbon atoms such as a 1-naphthyl group, a 2-methyl-1-naphthyl group, a 3-methyl-1-naphthyl group, a 4-methyl-1-naphthyl group, a 5-methyl-1-naphthyl group, a 6-methyl-1-naphthyl group, a 7-methyl-1-naphthyl group, a 8-methyl-1-naphthyl group, a 2,3-dimethyl-1-naphthyl group, a 2,4-dimethyl-1-naphthyl group, a 2,5-dimethyl-1-naphthyl group, a 2,6-dimethyl-1-naphthyl group, a 2,7-dimethyl-1-naphthyl group, a 2,8-dimethyl-1-naphthyl group, a 3,4-dimethyl-1-naphthyl group, a 3,5-dimethyl-1-naphthyl group, a 3,6-dimethyl-1-naphthyl group, a 3,7-dimethyl-1-naphthyl group, a 3,8-dimethyl-1-naphthyl group, a 4,5-dimethyl-1-naphthyl group, a 5,8-dimethyl-1-naphthyl group, a 4-ethyl-1-naphthyl group, a 2-naphthyl group, a 1-methyl-2-naphthyl group, a 3-methyl-2-naphthyl group, and a 4-methyl-2-naphthyl group; a naphtyl group or an alkyl-substituted naphtyl group further substituted with at least one group selected from a group consisting of a hydroxyl group, a carboxyl group, a cyano group, a nitro group, an alkoxyl group, an alkoxyalkyl group, an alkoxycarbonyl group, an alkoxycarbonyloxy group; and the like can be given.

As examples of the alkoxyl group, the alkoxyalkyl group, the alkoxycarbonyl group, and the alkoxycarbonyloxy group which are the substituents of the naphtyl group or alkyl-substituted naphtyl group, the groups given as examples of the substituents of the phenyl group or the alkyl-substituted phenyl groups can be given.

As a naphtyl group which may have a substituent represented by R¹⁸ in the formula (8), a 1-naphthyl group, a 1-(4-methoxynaphthyl) group, a 1-(4-ethoxynaphthyl) group, a 1-(4-n-propoxynaphtyl) group, a 1-(4-n-butoxynaphthyl) group, a 2-(7-methoxynaphtyl) group, a 2-(7-ethoxynaphtyl) group, a 2-(7-n-propoxynaphtyl) group, a 2-(7-n-butoxynaphtyl) group, and the like are preferable.

As an example of the divalent group having 2 to 10 carbon atoms formed by two R¹⁸ groups, a group forming a 5 or 6 member ring together with the sulfur atom in the formula (8), particularly preferably a 5 member ring (i.e. tetrahydrothiophene ring), is preferable. As examples of the substituent for the above divalent groups, the groups previously mentioned as the substituents for the phenyl group or the alkyl-substituted phenyl groups, such as a hydroxyl group, a carboxyl group, a cyano group, a nitro group, an alkoxyl group, an alkoxyalkyl group, an alkoxycarbonyl group, and an alkoxycarbonyloxy group can be given. As the group R¹⁸ in the formula (8), a methyl group, an ethyl group, a phenyl group, a 4-methoxyphenyl group, a 1-naphthyl group, a divalent group with a tetrahydrothiophene cyclic structure formed from the two R¹⁸ groups and the sulfur atom, and the like are preferable.

As examples of a preferable cation moiety in the formula (8), a triphenylsulfonium cation, tri-1-naphthylsulfonium cation, tri-tert-butylphenylsulfonium cation, 4-fluorophenyl-diphenylsulfonium cation, di-4-fluorophenyl-phenylsulfonium cation, tri-4-fluorophenylsulfonium cation, 4-cyclohexylphenyl-diphenylsulfonium cation, 4-methanesulfonylphenyl-diphenylsulfonium cation, 4-cyclohexanesulfonyl-diphenylsulfonium cation, 1-naphthyldimethylsulfonium cation, 1-naphthyldiethylsulfonium cation, 1-(4-hydroxynaphthyl)dimethylsulfonium cation, 1-(4-methylnaphthyl)dimethylsulfonium cation, 1-(4-methylnaphthyl)diethylsulfonium cation, 1-(4-cyanonaphthyl)dimethylsulfonium cation, 1-(4-cyanonaphthyl)diethylsulfonium cation, 1-(3,5-dimethyl-4-hydroxyphenyl)tetrahydrothiophenium cation, 1-(4-methoxynaphthyl)tetrahydrothiophenium cation, 1-(4-ethoxynaphthyl)tetrahydrothiophenium cation, 1-(4-n-propoxynaphthyl)tetrahydrothiophenium cation, 1-(4-n-butoxynaphthyl)tetrahydrothiophenium cation, 2-(7-methoxy naphthyl)tetrahydrothiophenium cation, 2-(7-ethoxynaphthyl)tetrahydrothiophenium cation, 2-(7-n-propoxynaphthyl)tetrahydrothiophenium cation, 2-(7-n-butoxynaphthyl)tetrahydrothiophenium cation, and the like can be given.

In the formula (8), the CₙF₂ₙ⁻ group in the anion moiety R²⁰CₙF₂ₙSO₃⁻ represented by X⁻ is a perfluoroalkylene group, with the alkylene group being either linear or branched and n being the number of carbon atoms, preferably 1, 2, 4, or 8. As a hydrocarbon group having 1 to 12 carbon atoms which may have a substituent represented by R²⁰, an alkyl group, a cycloalkyl group, and a bridged alicyclic hydrocarbon group having 1 to 12 carbon atoms are preferable. As specific examples, a methyl group, an ethyl group, an n-propyl group, an i-propyl group, an n-butyl group, a 2-methylpropyl group, a 1-methylpropyl group, a t-butyl group, an n-pentyl group, an neopentyl group, an n-hexyl group, a cyclohexyl group, an n-heptyl group, an n-octyl group, a 2-ethylhexyl group, an n-nonyl group, an n-decyl group, a norbornyl group, a norbornylmethyl group, a hydroxynorbornyl group, and an adamantyl group can be given.

As examples of a preferable anion moiety in the formula (8), a trifluoromethanesulfonate anion, perfluoro-n-butanesulfonate anion, perfluoro-n-octanesulfonate anion, 2-bicyclo[2.2.1]hept-2-yl-1,1,2,2-tetrafluoroethanesulfonate anion, 2-bicyclo[2.2.1]hept-2-yl-1,1-difluoroethanesulfonate anion, and the like can be given.

In the present invention, the acid generator 1 can be used either individually or in combination of two or more.

In the present invention, a radiation-sensitive acid generator other than the acid generator 1 can be used in combination (such an acid generator is hereinafter referred to as "other acid generator"). Examples of the other acid generator include onium salt compounds, halogen-containing compounds, diazoketone compounds, sulfone compounds, and sulfonate compounds other than the acid generator 1 can be given.

Specific examples of the other acid generator are as follows.

### Onium salt compounds:

As examples of the onium salt compounds, an iodonium salt, a sulfonium salt, a phosphonium salt, a diazonium salt, and a pyridinium salt can be given. As specific examples of the onium salt compounds, diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesulfonate, bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, cyclohexyl·2-oxocyclohexylo·methylsulfonium trifluoromethanesulfonate, dicyclohexyl-2-oxocyclohexylsulfonium trifluoromethanesulfonate, 2-oxocyclohexyldimethylsulfonium trifluoromethanesulfonate, and the like can be given.

### Halogen-containing compound:

As examples of the halogen-containing compound, haloalkyl group-containing hydrocarbon compounds and haloalkyl group-containing heterocyclic compounds can be given. As specific examples of the halogen-containing compound, (trichloromethyl)-s-triazine derivatives such as phenylbis(trichloromethyl)-s-triazine, 4-methoxyphenylbis(trichloromethyl)-s-triazine, 1-naphthylbis(trichloromethyl)-s-triazine, and 1,1-bis(4-chlorophenyl)-2,2,2-trichloroethane can be given.

### Diazoketone compound:

As examples of the diazoketone compound, 1,3-diketo-2-diazo compounds, diazobenzoquinone compounds, and diazonaphthoquinone compounds can be given. As specific examples of the diazoketone compound,
1,2-naphthoquinonediazido-4-sulfonyl chloride, 1,2-naphthoquinonediazido-5-sulfonyl chloride, 1,2-naphthoquinonediazido-4-sulfonate or
1,2-naphthoquinonediazido-5-sulfonate of 2,3,4,4'-tetrahydroxybenzophenone, and
1,2-naphthoquinonediazido-4-sulfonate or 1,2-naphthoquinonediazido-5-sulfonate of 1,1,1-tris(4-hydroxyphenyl)ethane can be given.

### Sulfone compound:

As examples of the sulfone compound, β-ketosulfone, β-sulfonylsulfone, and α-diazo compounds of these compounds can be given. As specific examples of the sulfone compound, 4-trisphenacylsulfone, mesitylphenacylsulfone, bis(phenylsulfonyl)methane, and the like can be given.

### Sulfonic acid compound:

As examples of the sulfonic acid compound, alkyl sulfonates, alkylimide sulfonates, haloalkyl sulfonates, aryl sulfonates, and imino sulfonates can be given. As specific examples of the sulfone compounds, benzointosylate, tris(trifluoromethanesulfonate) of pyrogallol, nitrobenzyl-9,10-diethoxyanthracene-2-sulfonate, trifluoromethanesulfonylbicyclo[2.2.1]hept-5-ene-2,3-dicarbodiimide, nonafluoro-n-butanesulfonylbicyclo[2.2.1]hept-5-ene-2,3-dicarbodiimide, perfluoro-n-octanesulfonylbicyclo[2.2.1]hept-5-ene-2,3-dicarbodiimide, 2-bicyclo[2.2.1]hept-2-yl-1,1,2,2-tetrafluoroethanesulfonylbicyclo[2.2,1]hept-5-ene-2,3-dicarbodiimide, N-(trifluoromethanesulfonyloxy)succinimide, N-(nonafluoro-n-butanesulfonyloxy)succinimide, N-(perfluoro-n-octanesulfonyloxy)succinimide, N-(2-bicyclo[2.2.1]hept-2-yl-1,1,2,2-tetrafluoroethanesulfonyloxy)succinimide, 1,8-naphthalenedicarboxylic acid imide trifluoromethanesulfonate, 1,8-naphthalenedicarboxylic acid imide nonafluoro-n-butanesulfonate, 1,8-naphthalenedicarboxylic acid imide perfluoro-n-octanesulfonate, and the like can be given.

Among these other acid generators, diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesulfonate, bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, cyclohexyl-2-oxocyclohexyl-methylsulfonium trifluoromethanesulfonate, dicyclohexyl-2-oxocyclohexylsulfonium trifluoromethanesulfonate, 2-oxocyclohexyldimethylsulfonium trifluoromethanesulfonate,
trifluoromethanesulfonylbicyclo[2.2.1]hept-5-ene-2,3-dicarbodiimide, nonafluoro-n-butanesulfonylbicyclo[2.2.1]hept-5-ene-2,3-dicarbodiimide, perfluoro-n-octanesulfonylbicyclo[2.2,1]hept-5-ene-2,3-dicarbodiimide, 2-bicyclo[2.2.1]hept-2-yl-1,1,2,2-tetrafluoroethanesulfonylbicyclo[2.2.1]hept-5-ene-2,3-dicarbodiimide, N-(trifluoromethanesulfonyloxy)succinimide, N-(nonafluoro-n-butanesulfonyloxy)succinimide, N-(perfluoro-n-octanesulfonyloxy)succinimide, N-(2-bicyclo[2.2.1]hept-2-yl-1,1,2,2-tetrafluoroethanesulfonyloxy)succinimide, 1,8-naphthalenedicarboxylic acid imide trifluoromethanesulfonate, and the like are preferale. These other acid generators may be used either individually or in combination of two or more.

As the acid generator, the acid generator 1 is preferably used, and the acid generator 1 is preferably used in combination with the other acid generators. When the other acid generators are used together, the proportion of the other acid generators is usually 80 wt% or less, and preferably 60 wt% or less of the total amount of the acid generator 1 and the other acid generators.

The total amount of the acid generator to be used in the present invention is preferably 0.1 to 20 parts by weight, and more preferably 0.5 to 10 parts by weight for 100 parts by weight of the copolymer from the viewpoint of ensuring sensitivity and developability as a resist. If this total amount is less than 0.1 part by weight, sensitivity and developability tend to decrease. If the amount exceeds 20 parts by weight, a rectangular resist pattern may not be obtained due to decreased radiation transmittance.

It is desirable that the radiation-sensitive resin composition of the present invention further comprise an acid diffusion controller in addition to the copolymer and the acid generators. The acid diffusion controller controls diffusion of an acid generated from the acid generator upon exposure in the resist film to suppress undesired chemical reactions in the unexposed area. The addition of such an acid diffusion controller improves storage stability of the resulting radiation-sensitive resin composition and resolution as a resist. Moreover, the addition of the acid diffusion controller prevents the line width of the resist pattern from changing due to changes in the post-exposure delay (PED) between exposure and post exposure heat treatment, whereby a composition with remarkably superior process stability can be obtained. Nitrogen-containing organic compounds are preferable as the acid diffusion controller.

As examples of such nitrogen-containing organic compounds, a compound shown by the following formula (9) (hereinafter called "nitrogen-containing compound (a)"): a compound having two nitrogen atoms in a molecule (hereinafter referred to as "nitrogen-containing compound (b)"); polyamino compounds and polymers having three or more nitrogen atoms in the molecule (hereinafter collectively referred to as "nitrogen-containing compound (c)"); and amide group-containing compounds, urea compounds, and nitrogen-containing heterocyclic compounds can be given. 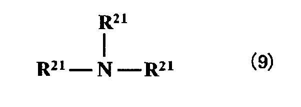 wherein R²¹ individually represents a hydrogen atom, a substituted or unsubstituted, linear, branched, or cyclic alkyl group, substituted or unsubstituted aryl group, or substituted or unsubstituted aralkyl group.

As the nitrogen-containing compound (a), mono(cyclo)alkylamines such as n-hexylamine, n-heptylamine, n-octylamine, n-nonylamine, n-decylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, methyldicyclohexylamine, and tricyclohexylamine; substituted alkyl amines such as 2,2',2"-nitrotriethanol; and aromatic amines such as aniline, N-methylaniline, N,N-dimethylaniline, 2-methylaniline, 3-methylaniline, 4-methylaniline, 4-nitroaniline, diphenylamine, triphenylamine, naphthylamine, 2,4,6-tri-tert-butyl-N-methylaniline, N-phenyldiethanolamine, 2,6-diisopropylaniline; are preferable.

Examples of the preferable nitrogen-containing compounds (b) include ethylenediamine, N,N,N',N'-tetramethylethylenediamine, tetramethylenediamine, hexamethylenediamine, 4,4'-diaminodiphenylmethane, 4,4'-diamino diphenyl ether, 4,4'-diaminobenzophenone, 4,4'-diaminodiphenylamine, 2,2'-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene, bis(2-dimethylaminoethyl)ether, bis(2-diethylaminoethyl) ether, 1-(2-hydroxyethyl)-2-imidazolizinone, 2-quinoxalinol, N,N,N',N'-tetrakis(2-hydroxypropyl)ethylenediamine, and N,N,N',N",N"-pentamethyldiethylenetriamine.

As examples of the preferable nitrogen-containing compound (c), polyethyleneimine, polyallylamine, and a polymer of 2-dimethylaminoethylacrylamide can be given.

As examples of the preferable amide group-containing compounds, N-t-butoxycarbonyl group-containing amino compounds such as N-t-butoxycarbonyldi-n-octylamine, N-t-butoxycarbonyldi-n-nonylamine, N-t-butoxycarbonyldi-n-decylamine, N-t-butoxycarbonyldicyclohexylamine, N-t-butoxycarbonyl-1-adamantylamine, N-t-butoxycarbonyl-2-adamantylamine, N-t-butoxycarbonyl-N-methyl-1-adamantylamine, (S)-(-)-1-(t-butoxycarbonyl)-2-pyrrolidinemethanol, (R)-(+)-1-(t-butoxycarbonyl)-2-pyrrolidinemethanol, N-t-butoxycarbonyl-4-hydroxypiperidine, N-t-butoxycarbonylpyrrolidine, N-t-butoxycarbonylpiperazine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N-di-t-butoxycarbonylhexamethylenediamine, N,N,N'N'-tetra-t-butoxycarbonylhexamethylenediamine, N,N'-di-t-butoxycarbonyl-1,7-diaminoheptane, N,N'-di-t-butoxycarbonyl-1,8-diaminonooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, N-t-butoxycarbonyl-2-phenylbenzimidazole; formamide, N-methylformamide, N,N-dimethylformamide, acetamide, N-methylacetamide, N,N-dimethylacetamide, propionamide, benzamide, pyrrolidone, N-methylpyrrolidone, N-acetyl-1-adamantylamine, tris(2-hydroxyethyl)isocyanuric acid, and the like can be given.

As examples of the preferable urea compounds, urea, methylurea, 1,1-dimethylurea, 1,3-dimethylurea, 1,1,3,3-tetramethylurea, 1,3-diphenylurea, and tri-n-butylthiourea can be given. As examples of the preferable nitrogen-containing heterocyclic compounds, imidazoles such as imidazole, 4-methylimidazole, 4-methyl-2-phenylimidazole, benzimidazole, 2-phenylbenzimidazole, 1-benzyl 2-methylimidazole, and 1-benzyl-2-methyl-1H-imidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, acridine, and 2,2':6',2"-tarpyridine; piperazines such as piperazine and 1-(2-hydroxyethyl)piperazine; as well as pyrazine, pyrazole, pyridazine, quinoxaline, purine, pyrrolidine, piperidine, piperidine ethanol, 3-piperidino-1,2-propanediol, morpholine, 4-methylmorpholine, 1-(4-morpholinyl)ethanol, 4-acetylmorpholine, 3-(N-morpholino)-1,2-propanediol, 1,4-dimethylpiperazine, and 1,4-diazabicyclo[2.2.2]octane can be given.

The acid diffusion controller may be used either individually or in combination of two or more. The amount of the acid diffusion controller to be used is usually 0.001 to 15 parts by weight, preferably 0.001 to 10 parts by weight, and still more preferably 0.001 to 5 parts by weight for 100 parts by weight of the copolymer. If the amount of the acid diffusion controllers exceeds 15 parts by weight, sensitivity as a resist tends to decrease. If the amount is less than 0.001 part by weight, the pattern shape or dimensional accuracy as a resist may decrease depending on the processing conditions.

It is desirable that the radiation-sensitive resin composition of the present invention comprise the above mentioned copolymer, acid generator, and acid diffusion controller dissolved in a solvent. As the solvent, at least one compound selected from the group consisting of propylene glycol mono-methyl ether acetate, 2-heptanone, and cyclohexanone (hereinafter referred to as "solvent 1") is preferable. Solvents other than the solvent 1 (hereinafter referred to as "other solvents") can also be used. The solvent 1 and the other solvents can be used in combination.

As the other solvents, propylene glycol monoalkyl ether acetates such as propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate;
linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, and 2-octanone; cyclic ketones such as cyclopentanone, 3-methylcyclopentanone, 2-methylcyclohexanone, 2,6-dimethylcyclohexanone, and isophorone; alkyl-2-hydroxypropionates such as methyl-2-hydroxypropionate, ethyl-2-hydroxypropionate, n-propyl-2-hxdroxypropionate, i-propyl-2-hydroxypropionate, n-butyl-2-hydroxy propionate, i-butyl-2-hydroxypropionate, sec-butyl-2-hydroxypropionate , and t-butyl-2-hydroxypropionate; alkyl-3-alkoxypropionates such as methyl-3-methoxypropionate, ethyl-3-methoxypropionate, methyl-3-ethoxypropionate, ethyl-3-ethoxypropionate;
as well as n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methyl propionate, ethoxyethyl acetate, ethyl hydroxyacetate, methyl 2-hydroxy-3-methylbutyrate, 3-methoxybutylacetate, 3-methyl-3-methoxybutylacetate,
3-methyl-3-methoxybutylpropionate, 3-methyl-3-methoxybutylbutyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, and propylene carbonate can be given.

Among these other solvents, linear or branched ketones, cyclic ketones, propylene glycol monoalkyl ether acetates, alkyl 2-hydroxypropionates, alkyl 3-alkoxypropionates, and γ-butyrolactone are preferable. These other solvents may be used either individually or in combination of two or more.

When the mixture of the solvent 1 and the other solvents are used, the proportion of the other solvents to be added is 50 wt% or less, preferably 30 wt% or less, and more preferably 25 wt% or less of the total amount of solvents used. The solvent is used in the radiation-sensitive resin composition of the present invention in an amount to make the concentration of the total solid content of the composition usually 2 to 70 wt%, preferably 4 to 25 wt%, and more preferably 4 to 10 wt%.

Other additives such as surfactants, sensitizers, and aliphatic additives can be optionally added to the radiation-sensitive resin composition of the present invention.

The surfactant improves applicability, striation, developability, and the like of the radiation-sensitive resin composition. As examples of the surfactant, nonionic surfactants such as polyoxyethylene lauryl ether, polyoxyethylene stearyl ether, polyoxyethylene oleyl ether, polyoxyethylene n-octyl phenyl ether, polyoxyethylene n-nonyl phenyl ether, polyethylene glycol dilaurate, and polyethylene glycol distearate; and commercially available products such as "KP341" (manufactured by Shin-Etsu Chemical Co., Ltd.), "POLYFLOW No. 75" and "POLYFLOW No. 95" (manufactured by Kyoeisha Chemical Co., Ltd.), "FTOP EF301", "FTOP EF303", and "FTOP EF352" (manufactured by Tohkem Products Corp.), "MEGAFAC F171" and "MEGAFAC F173" (manufactured by Dainippon Ink and Chemicals, Inc.), "Fluorad FC430" and "Fluorad FC431" (manufactured by Sumitomo 3M Ltd.), "Asahi Guard AG710" and "Surflon S-382", "Surflon SC-101", "Surflon SC-102", "Surflon SC-103", "Surflon SC-104", "Surflon SC-105", and "Surflon SC-106" (manufactured by Asahi Glass Co., Ltd.) can be given.

These surfactants may be used either individually or in combination of two or more. The amount of the surfactants to be added is usually 2 parts by weight or less for 100 parts by weight of the polymer.

The sensitizers absorb radiation energy and transmit the energy to the acid generator, thereby increasing the amount of an acid generated upon exposure. The sensitizers improve apparent sensitivity of the radiation-sensitive resin composition. As examples of the sensitizer, carbazoles, acetophenones, benzophenones, naphthalenes, phenols, biacetyl, Eosine, Rose Bengal, pyrenes, anthracenes, phenothiazines, and the like can be given. These sensitizers may be used either individually or in combination of two or more. Addition of a dye or a pigment visualizes a latent image in the exposed area, thereby decreasing the effects of halation during exposure. Use of an adhesion improver improves adhesion to the substrates.

These sensitizers may be used either individually or in combination of two or more. The amount of the sensitizers to be added is usually 50 parts by weight or less for 100 parts by weight of the polymer.

Alicyclic additives having an acid-dissociable group and alicyclic additives having no acid-dissociable group may be added to the radiation-sensitive resin composition of the present invention. The alicyclic additives having an acid-dissociable group and alicyclic additives having no acid-dissociable group improve dry etching resistance, pattern shape, and adhesion to the substrate. As examples of the alicyclic additives, adamantane derivatives such as 1-adamantane carboxylate, 2-adamantanon, t-butyl-1-adamantane carboxylate, t-butoxycarbonylmethyl-1-adamantane carboxylate, α-butyrolactone-1-adamantane carboxylate, di-t-butyl-1,3-adamantanedicarboxylate, t-butyl-1-adamantane acetate, t-butoxycarbonylmethyl-1-adamantane acetate, di-t-butyl-1,3-adamantane diacetate, and 2,5-dimethyl-2,5-di(adamantylcarbonyloxy)hexane; deoxycholates such as t-butyl-deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, and mevalonolactone deoxycholate; lithocholates such as t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, mevalonolactone lithocholate; alkyl carboxylates such as dimethyl adipate, diethyl adipate, dipropyl adipate, di-n-butyl adipate, and di-t-butyl adipate; 3-[2-hydroxy-2,2-bis(trifluoromethyl)ethyl]tetracyclo[4.4.0.1^{2,5}.1^{7,10}]dodecane, and the like can be given.

These alicyclic additives may be used either individually or in combination of two or more. The amount of the alicyclic additives to be added is usually 50 parts by weight or less, and preferably 30 parts by weight or less for 100 parts by weight of the copolymer. If the amount of the alicyclic additives exceeds 50 parts by weight, heat resistance as a resist tends to decrease.

As other additives, low molecular weight alkali solubility controllers containing an alkali-soluble resin and/or acid dissociable protecting group, halation inhibitors, preservation stabilizers, antifoaming agents, and the like can be given.

The radiation-sensitive resin composition of the present invention is particularly useful as a chemically-amplified resist used in liquid immersion lithography in which a liquid with a high refractive index is used.

A resist pattern is formed from the radiation-sensitive resin composition of the present invention by applying the composition solution to, for example, substrates such as a silicon wafer or a wafer coated with aluminum using an appropriate application method such as rotational coating, cast coating, and roll coating to form a resist film. The resist film is then optionally pre-baked (hereinafter called "PB") and exposed to radiation via an organic immersion medium to form a specific resist pattern. As examples of the radiation used, deep ultraviolet rays such as a KrF excimer laser (wavelength: 248 nm), an ArF excimer laser (wavelength: 193 nm), an F2 excimer laser (wavelength: 157 nm), or EUV (extreme ultraviolet, wavelength: 13 nm and the like), X-rays such as synchrotron radiation, and charged particle rays such as electron beams can be given. The exposure conditions such as the light exposure are appropriately determined depending on the composition of the radiation-sensitive resin composition, types of additives, and the like.

In the present invention, it is preferable to treat the resist film with heat after exposure to light (hereinafter called "PEB"). The PEB ensures smooth dissociation of the acid-dissociable group in the copolymer (dissociation of protective groups which protect alkali-soluble sites). The heating temperature for the PEB is usually 30 to 200°C, and preferably 50 to 170°C, although the heating conditions are changed depending on the composition of the radiation-sensitive resin composition.

In order to bring about the maximum potentiality of the radiation-sensitive resin composition of the present invention, an organic or inorganic anti-reflection film may be formed on a substrate as disclosed in JP-B-6-12452, for example. Moreover, a protection film may be formed on the resist film as disclosed in JP-A-5-188598, for example, in order to prevent the effects of basic impurities and the like in an environmental atmosphere. These techniques may be employed in combination.

The exposed resist film is then developed to form a prescribed resist pattern. As preferable examples of the developer used for development, alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, and 1,5-diazabicyclo-[4.3.0]-5-nonene are given. The concentration of the alkaline aqueous solution is usually 10 wt% or less. If the concentration of the alkaline aqueous solution exceeds 10 wt%, an unexposed area may also be dissolved in the developer.

Organic solvents or the like may be added to the developer containing the alkaline aqueous solution. As examples of the organic solvent, ketones such as acetone, methyl ethyl ketone, methyl i-butyl ketone, cyclopentanone, cyclohexanone, 3-methylcyclopentanone, and 2,6-dimethylcyclohexanone; alcohols such as methylalcohol, ethylalcohol, n-propylalcohol, i-propylalcohol, n-butylalcohol, t-butylalcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol; acetonylacetone; and dimethylformamide can be given. These organic solvents may be used either individually or in combination of two or more.

The amount of the organic solvent to be used is preferably 100 vol% or less for 100 vol% of the alkaline aqueous solution. The amount of the organic solvent exceeding 100 vol% may decrease developability, giving rise to a larger undeveloped portion in the exposed area. In addition, surfactants or the like may be added to the developer containing the alkaline aqueous solution in an appropriate amount. After development using the alkaline aqueous solution developer, the resist film is generally washed with water and dried.

The radiation-sensitive resin composition of the present invention is suitable for use in liquid immersion lithography using an immersion liquid with a high refractive index, particularly an alicyclic hydrocarbon compound and/or a chain-like saturated hydrocarbon compound having a refractive index of more than 1.44, but less than 1.85 at a wavelength of 193 nm.

As examples of the alicyclic saturated hydrocarbon compound used in liquid immersion lithography, the compounds of the following formulas (10-1) and (10-2) will be described.

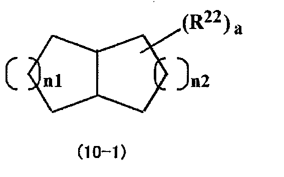

In the formula (10-1), R²² represents an aliphatic hydrocarbon group having 1 to 10 carbon atoms, an alicyclic hydrocarbon group having 3 to 14 carbon atoms, a cyano group, a hydroxyl group, a fluorine atom, a fluorine-substituted hydrocarbon group having 1 to 10 carbon atoms, a group -Si(R³⁰)₃, or a group -SO₃R³¹, n1 and n2 individually represent integers from 1 to 3, a represents an integer from 0 to 10, provided that, when two or more R²²s exist, the R²²s may be the same or different, and two or more R²²s may bonded together to form a ring structure, and R³⁰ and R³¹ represent alkyl groups having 1 to 10 carbon atoms.

As the aliphatic hydrocarbon group having 1 to 10 carbon atoms represented by R²², a methyl group, an ethyl group, an n-propyl group, and the like can be given. As examples of the ring structure formed when two or more R²²s are bonded, a cyclopentyl group, a cyclohexyl group, and the like can be given. As examples of the alicyclic hydrocarbon group having 3 to 14 carbon atoms, a cyclohexyl group, a norbornyl group, and the like can be given. As examples of the fluorine-substituted hydrocarbon group having 1 to 10 carbon atoms, a trifluoromethyl group, a pentafluoroethyl group, and the like can be given. As examples of the alkyl group having 1 to 10 carbon atoms represented by R³⁰ of the group -Si(R³⁰)₃ and R³¹ of the group -SO₃R³¹, a methyl group, an ethyl group, and the like can be given.

As the substituents of R²² in the formula (10-1), a saturated aliphatic hydrocarbon group having 1 to 10 carbon atoms, a saturated alicyclic hydrocarbon group having 3 to 14 carbon atoms, a cyano group, a fluorine atom, and a fluorine-substituted saturated hydrocarbon group having 1 to 10 carbon atoms are preferable due to the high transmittance of radiation with a wavelength of 193 nm.

Of these, the saturated aliphatic hydrocarbon group having 1 to 10 carbon atoms and the saturated alicyclic hydrocarbon group having 3 to 14 carbon atoms are particularly preferable, since the resulting product exhibits a higher refractive index and a small interaction with a resist and rarely causes defects due to elution of a water-soluble component in a resist or erosion of a lens material.

It is preferable that n1 and n2 be 1 to 3, and particularly preferably 1 or 2. It is preferable that a be 0, 1, or 2. It is particularly preferable that a be 0, since the refractive index for light with a wavelength of 193 nm increases, for example.

Specific examples of preferred saturated alicyclic hydrocarbon compounds of the formula (10-1) are given below.

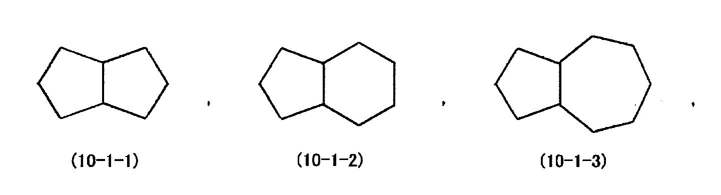

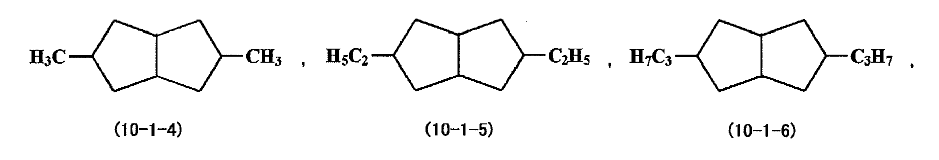

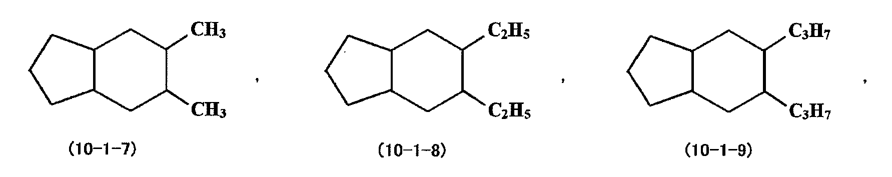

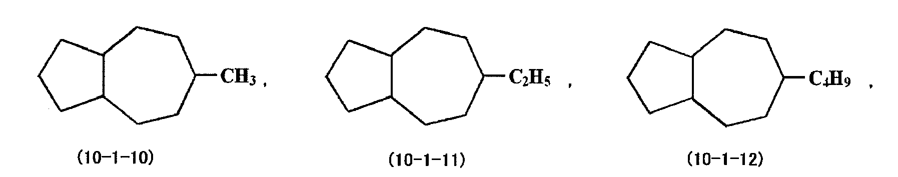

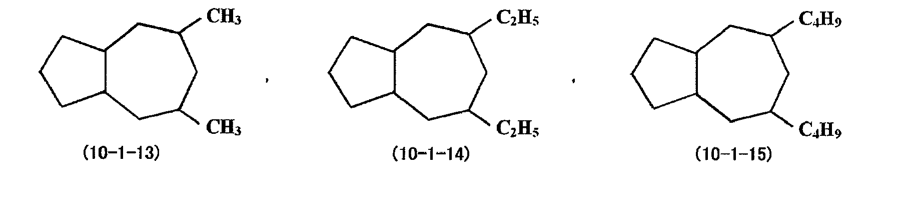

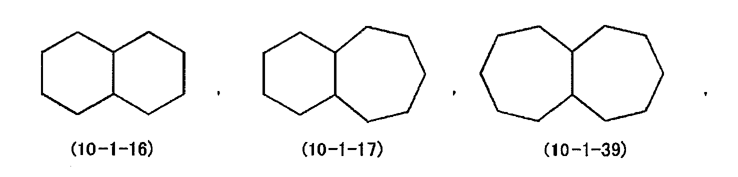

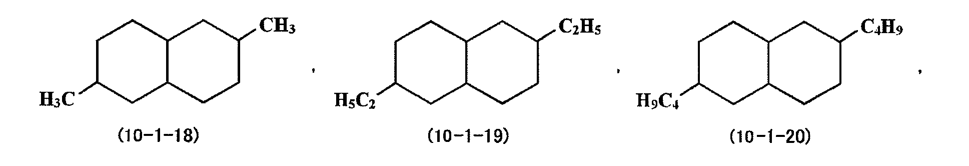

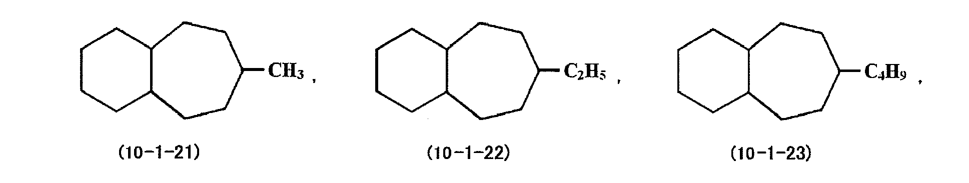

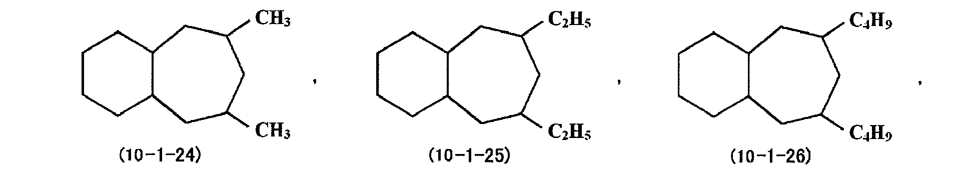

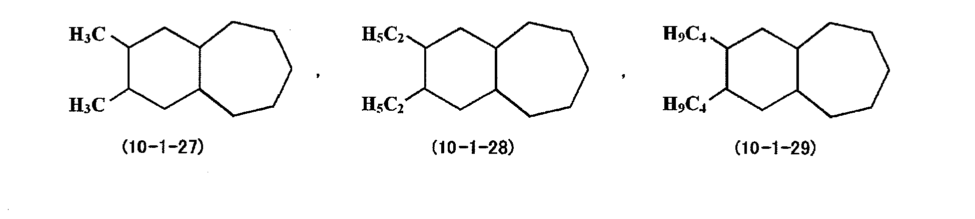

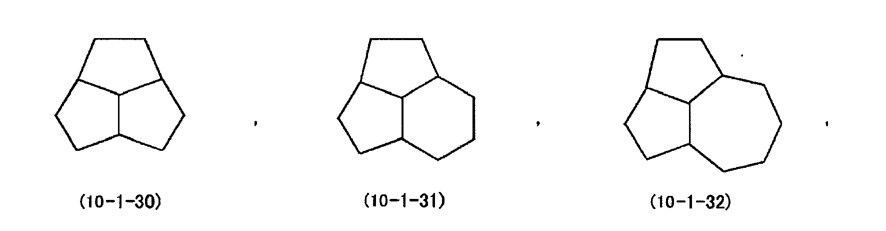

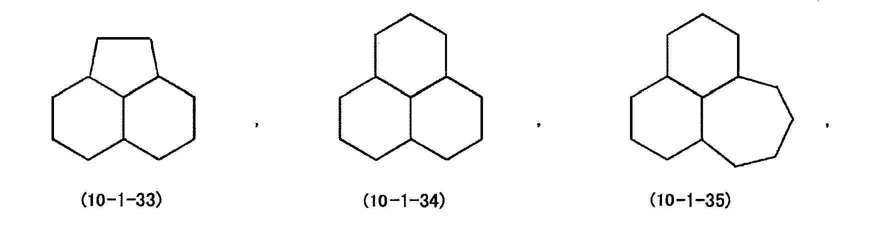

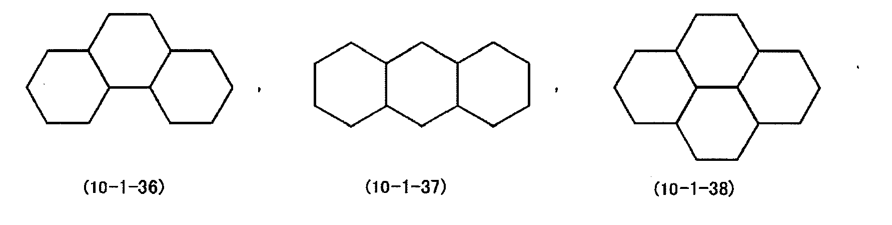

Of these, a compound which does not have a substituent is preferable, since the refractive index of light with a wavelength of 193 nm, for example, increases. As examples of preferred compounds, cis-decalin and trans-decalin can be given. 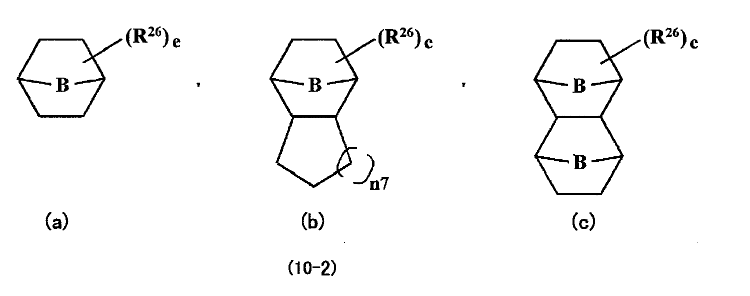 wherein B represents a methylene group or an ethylene group, R²⁶ represents an aliphatic hydrocarbon group having 1 to 10 carbon atoms, an alicyclic hydrocarbon group having 3 to 14 carbon atoms, a cyano group, a hydroxyl group, a fluorine atom, a fluorine-substituted hydrocarbon group having 1 to 10 carbon atoms, -Si(R³⁰)₃ group, or -SO₃R³¹ group, provided that, when two or more R²⁶s exist, the R²⁶s may be the same or different, and two or more R²⁶s may bond together to form a ring structure, e is an integer from 0 to 10, n7 represents an integer from 1 to 3, and R³⁰ and R³¹ represent an alkyl group having 1 to 10 carbon atoms.

R²⁶ is the same as R²² in the formula (10-1).

As the substituents of R²⁶ in the formula (10-2), a saturated aliphatic hydrocarbon group having 1 to 10 carbon atoms, a saturated alicyclic hydrocarbon group having 3 to 14 carbon atoms, a cyano group, a fluorine atom, and a fluorine-substituted saturated hydrocarbon group having 1 to 10 carbon atoms are preferable due to the high transmittance of radiation with a wavelength of 193 nm.

Of these substituents, an aliphatic saturated hydrocarbon group having 1 to 10 carbon atoms and an alicyclic saturated hydrocarbon group having 3 to 14 carbon atoms are preferable for the same reason as for R²² in the formula (10-1).

It is preferable that e be 0, 1, or 2. It is preferable that n7 be 1 to 3, and particularly preferably 1 or 2. It is particularly preferable that e be 0, since the refractive index of light with a wavelength of 193 nm, for example, increases. Examples of preferred compounds of the formula (10-2) are given below.

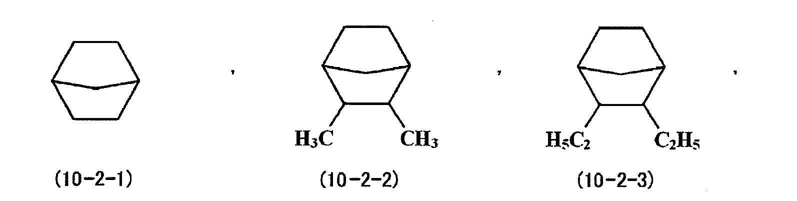

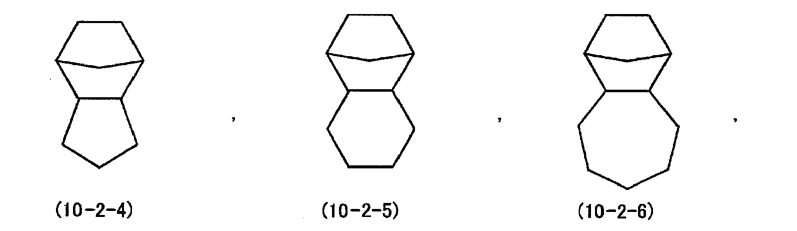

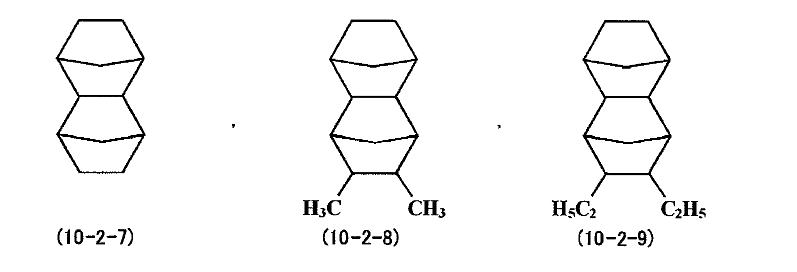

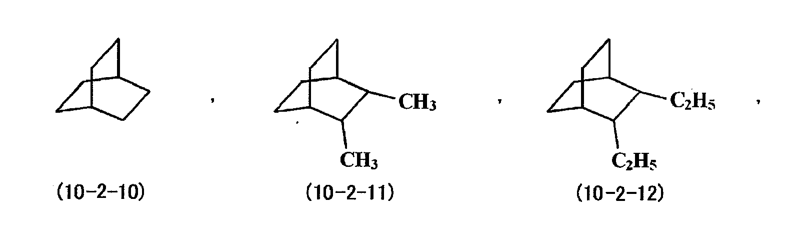

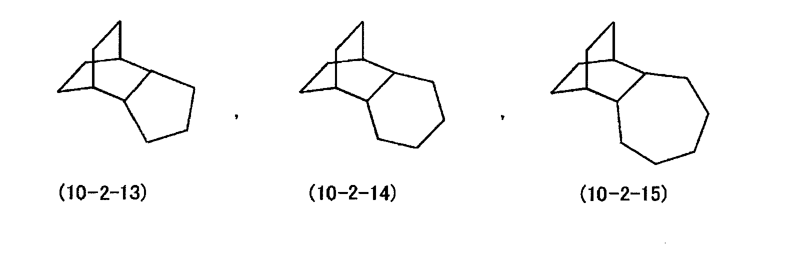

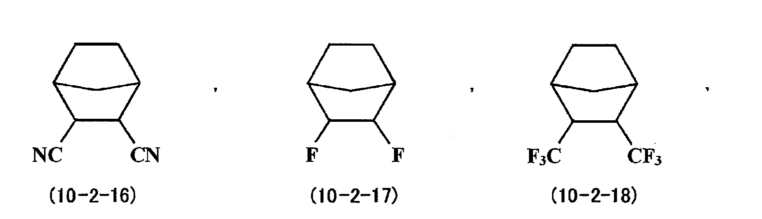

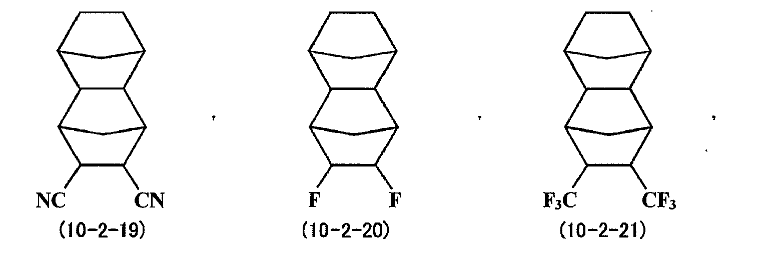

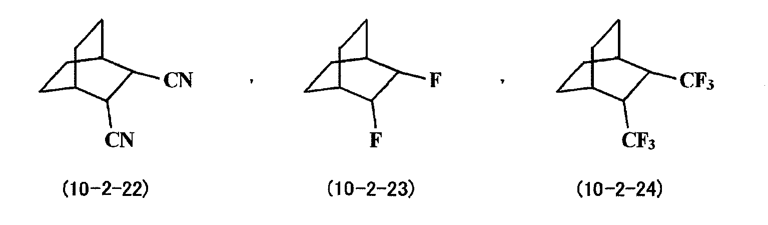

As a specific example of a preferred compound, exo-tricyclo[3.2.1.0^{2,6}]decane can be given.

Chain-like saturated hydrocarbon compounds which can be used as a liquid for liquid immersion lithography are preferably saturated hydrocarbon compounds which do not contain a cyclic structure in the molecule.

As examples of the chain-like saturated hydrocarbon compound, a linear saturated hydrocarbon compound and a branched saturated hydrocarbon compound can be given.

As examples of the linear saturated hydrocarbon compound, pentane, hexane, heptane, octane, nonane, decane, undecane, dodecane, tridecane, tetradecane, pentadecane, hexadecane, heptadecane, octadecane, nonadecane, icosane, heneicosane, docosane, tricosane, tetracosane, pentacosane, hexacosane, heptacosane, octacosane, nonacosane, triacontane, and tetracontane can be given.

As specific examples of the branched saturated hydrocarbon compounds, squalane and pristine can be given.

Among these saturated hydrocarbon compounds, compounds having 10 to 40 carbon atoms, particularly 14 to 40 carbon atoms are preferable due to the high refractive index and the properties of being a liquid with a low viscosity at a temperature range in which the aligner is operated.

Among these chain-like saturated hydrocarbon compounds, compounds having a straight-chain structure are particularly preferable due to the high resistance to oxidation reactions caused by oxygen and ozone generated under the exposure conditions.

### EXAMPLES

Measurements and evaluation in the Examples and Comparative Examples were carried out as follows.

### (1) Mw and Mn

The Mw and Mn were measured by gel permeation chromatography (GPC) using GPC columns (manufactured by Tosoh Corp., "G2000HXL" x 2, "G3000HXL" x 1, "G4000HXL" x 1) under the following conditions: flow rate: 1.0 ml/min, eluate: tetrahydrofuran, column temperature: 40°C, and standard reference material: monodispersed polystyrene. Dispersibility Mw/Mn was calculated from the measurement result.

### (2) Amount of low-molecular components containing monomers as major components

The amount of low-molecular components was measured by high performance liquid chromatography (HPLC) using "Intersil ODS-25 µm column" (4.6 mmϕ × 250 mm) manufactured by GL Sciences Inc., at a flow rate of 1.0 ml/min using an acrylonitrile/0.1% phosphoric acid aqueous solution as an eluate.

The term, low-molecular components, refers to a compound having a molecular weight of less than 1000, preferably a trimer or a less compound.

### (3) ¹³C-NMR Analysis

¹³C-NMR analysis of each of the polymers was carried out using "JNM-EX270" (manufactured by JEOL Ltd.) and CDCl₃ as a measuring solvent.

### Synthesis Example 1

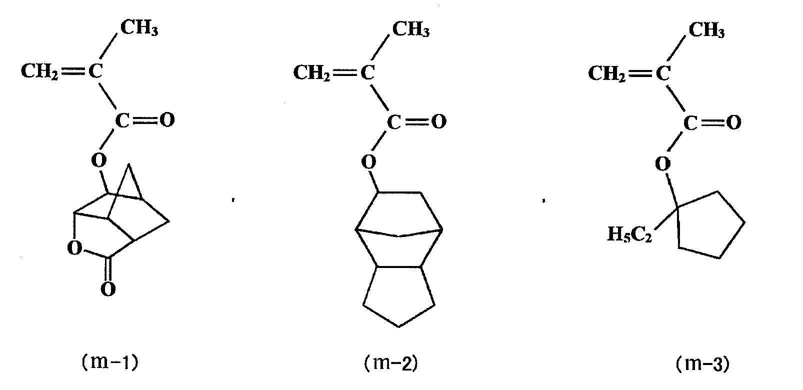

A monomer solution was prepared by dissolving 53.93 g (50 mol%) of the above compound (m-1), 10.69 g (10 mol%) of the above compound (m-2), and 35.38 g (40 mol%) of the above compound (m-3) in 200 g of 2-butanone, and further adding 5.58 g of dimethyl 2,2'-azobis(2-methylpropionate). A 1000 ml three-necked flask was charged with 100 g of 2-butanone and nitrogen gas was bubbled into the flask for 30 minutes. After the nitrogen purge, the flask was heated to 80°C with stirring, and the above monomer solution was added dropwise using a dripping funnel over three hours. The polymerization reaction was carried out for six hours after initiation of dripping. After completion of polymerization, the polymer solution was cooled with water to 30°C or lower and poured into 2000 g of methanol. A white precipitate produced was collected by filtration. The white powder collected by filtration was washed twice with 400 g of methanol in a slurry state, filtered again, and dried for 17 hours at 50°C to obtain a polymer in the form of white powder (74 g, yield 74%). The polymer was a copolymer with an Mw of 6900 and the mol% ratio of the following recurring units determined by ¹³C-NMR was 53.0 : 9.8 : 37.2 (mol%). This polymer is referred to as "acrylic polymer (A-1)".

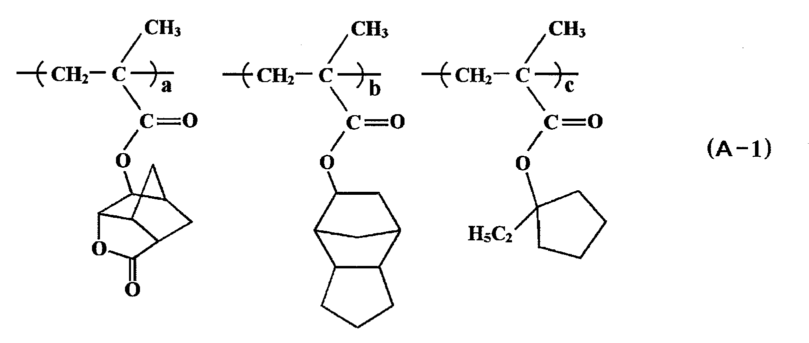

Polymer (A-1) Copolymerization ratio: a/b/c = 53.0/9.8/37.2, Mw/Mn = 1.70, Mw = 6900, amount of remaining low molecular weight components (wt%) = 0.03

The following polymers (A-2) to (A-6) were synthesized in the same manner.

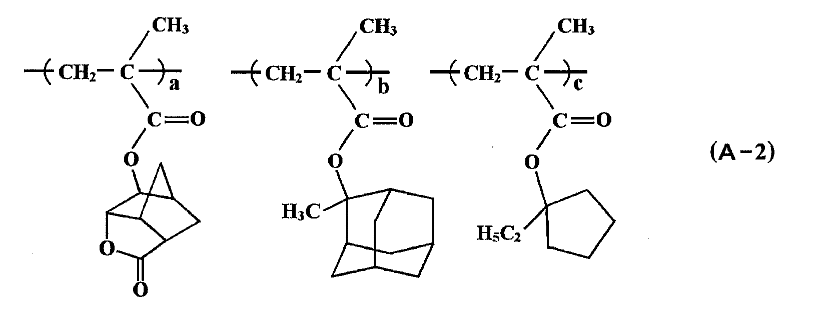

Polymer (A-2) Copolymerization ratio: a/b/c = 50/37/13, Mw/Mn = 1.62, Mw = 5200, amount of remaining low molecular weight components (wt%) = 0.03

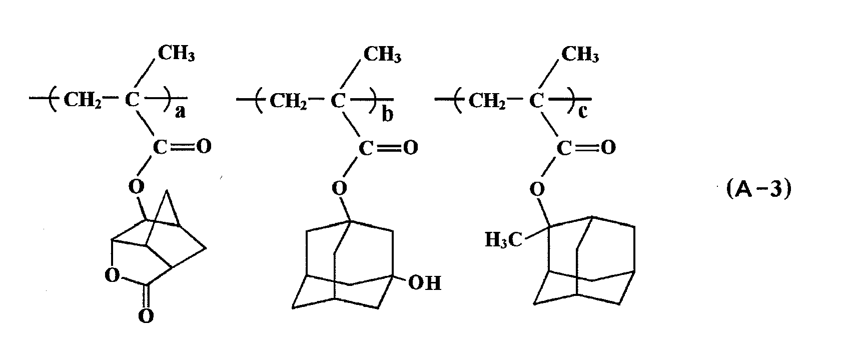

Polymer (A-3) Copolymerization ratio: a/b/c = 47.3/15.8/36.9, Mw/Mn = 1.60, Mw = 5000, amount of remaining low molecular weight components (wt%) = 0.05

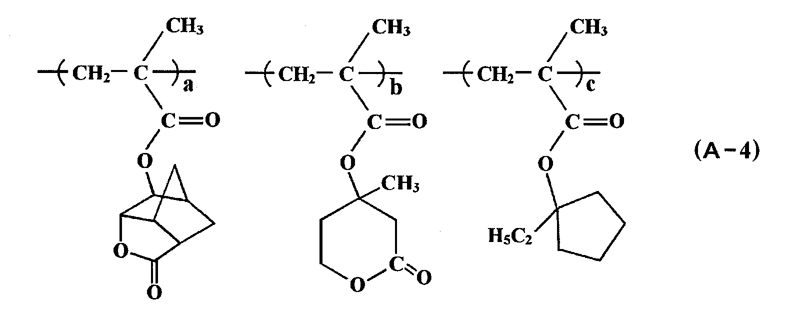

Polymer (A-4) Copolymerization ratio: a/b/c = 53.6/9.8/36.6, Mw/Mn = 1.69, Mw = 8100, amount of remaining low molecular weight components (wt%) = 0.04

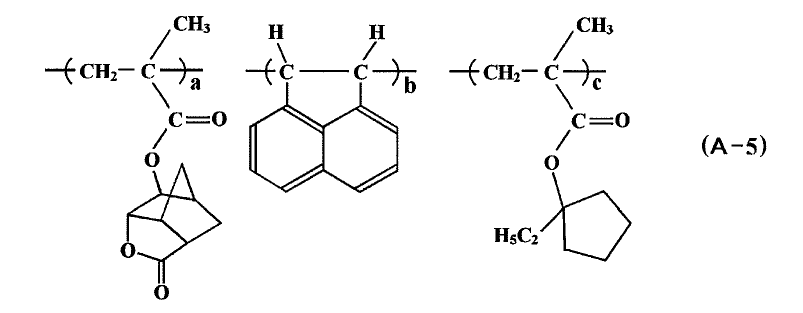

Polymer (A-5) Copolymerization ratio: a/b/c = 53.6/9.8/36.6, Mw/Mn = 1.62, Mw = 6100, amount of remaining low molecular weight components (wt%) = 0.03

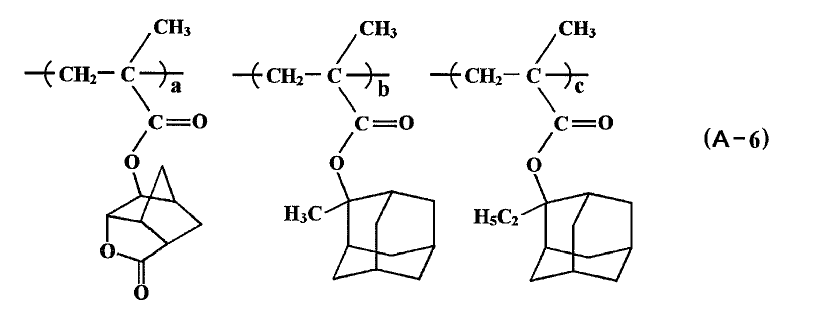

Polymer (A-6) Copolymerization ratio: a/b/c = 50.0/36.9/13.1, Mw/Mn = 1.78, Mw = 8200, amount of remaining low molecular weight components (wt%) = 0.03 Synthesis Example 2

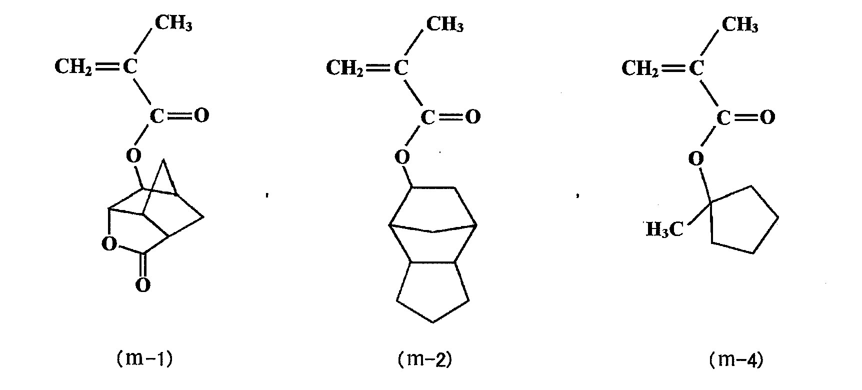

A monomer solution was prepared by dissolving 55.44 g (50 mol%) of the above compound (m-1), 10.99 g (10 mol%) of the above compound (m-2), and 33.57 g (40 mol%) of the above compound (m-4) in 200 g of 2-butanone, and further adding 4.10 g of dimethyl 2,2'-azobis(2-methylpropionitrile). A 1000 ml three-necked flask was charged with 100 g of 2-butanone and nitrogen gas was bubbled into the flask for 30 minutes. After the nitrogen purge, the flask was heated to 80°C with stirring, and the above monomer solution was added dropwise using a dripping funnel over three hours. The polymerization reaction was carried out for six hours after initiation of dripping. After completion of polymerization, the polymer solution was cooled with water to 30°C or lower and poured into 2000 g of methanol. A white precipitate produced was collected by filtration. The white powder collected by filtration was washed twice with 400 g of methanol in a slurry state, filtered again, and dried at 50°C for 17 hours to obtain a polymer in the form of a white powder (72 g, yield 72%). The polymer was a copolymer with an Mw of 6800 and the mol% ratio of the following recurring units determined by ¹³C-NMR was 51.0:10.8:38.2 (mol%). This polymer is referred to as "acrylic polymer (B-1)".

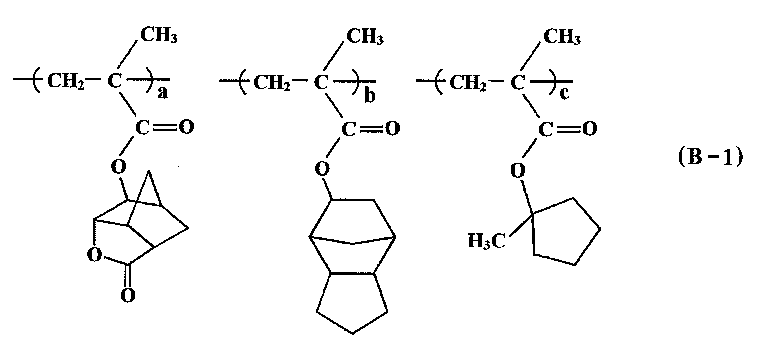

Polymer (B-1) Copolymerization ratio: a/b/c = 51.0/10.8/38.2, Mw/Mn = 1.58, Mw = 6300, amount of remaining low molecular weight components (wt%) = 0.03

The following polymers (B-2) to (B-6) were synthesized in the same manner.

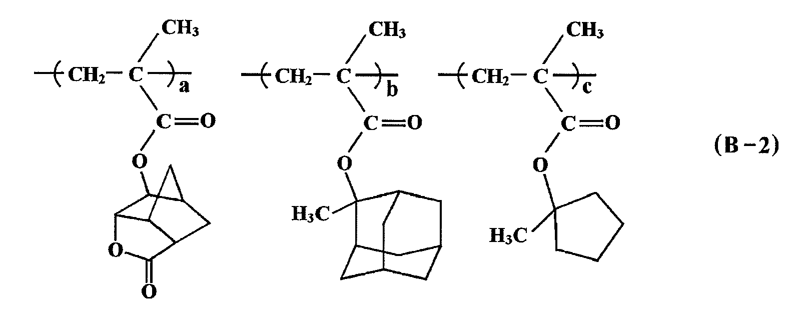

Polymer (B-2) Copolymerization ratio: a/b/c = 50.0/36.0/14.0, Mw/Mn = 1.63, Mw = 5800, amount of remaining low molecular weight components (wt%) = 0.04

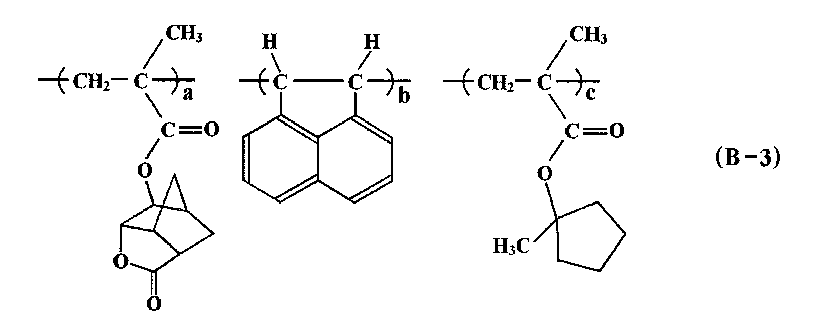

Polymer (B-3) Copolymerization ratio: a/b/c = 50.3/10.4/39.3, Mw/Mn = 1.70, Mw = 7100, amount of remaining low molecular weight components (wt%) = 0.03

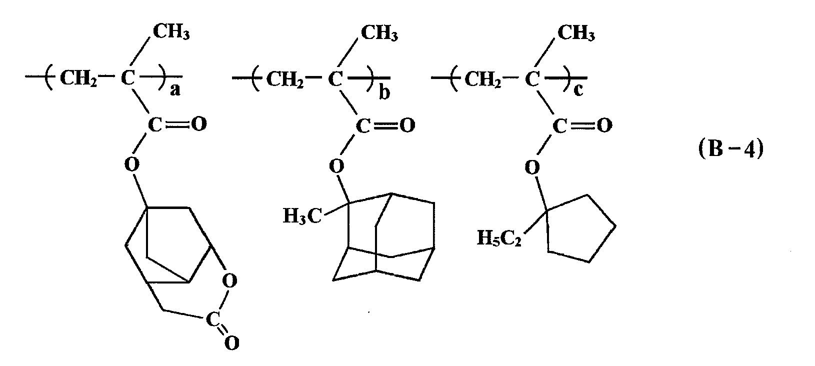

Polymer (B-4) Copolymerization ratio: a/b/c = 40.0/46.7/13.3, Mw/Mn = 1.70, Mw = 5900, amount of remaining low molecular weight components (wt%) = 0.03

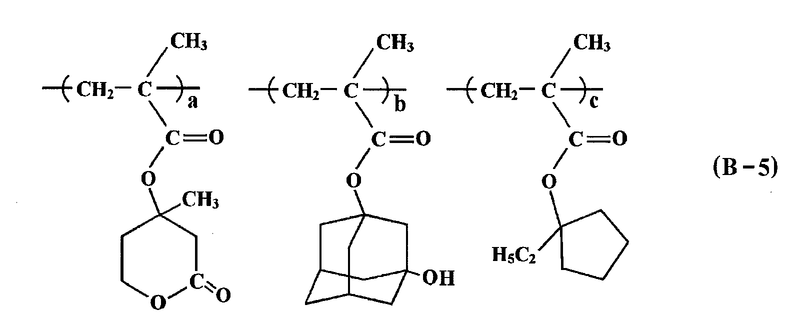

Polymer (B-5) Copolymerization ratio: a/b/c = 29.1/23.7/47.2, Mw/Mn = 1.78, Mw = 5700, amount of remaining low molecular weight components (wt%) = 0.05

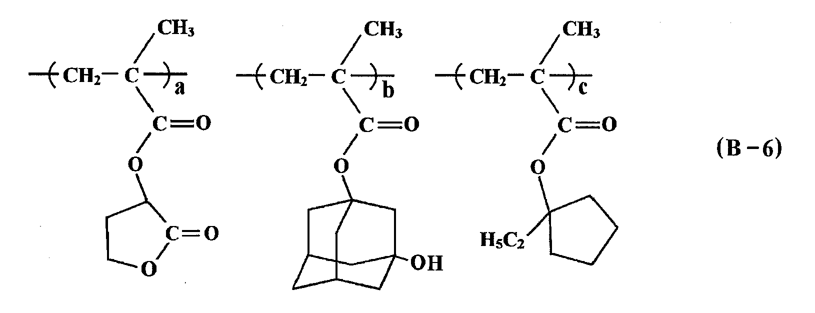

Polymer (B-6) Copolymerization ratio: a/b/c = 31.4/28.5/40.1, Mw/Mn = 1.93, Mw = 6900, amount of remaining low molecular weight components (wt%) = 0.08 Synthesis Example 3

The following polymers (C-1) and (C-2) used for Comparative Examples were synthesized in the same manner as in Synthesis Example 1.

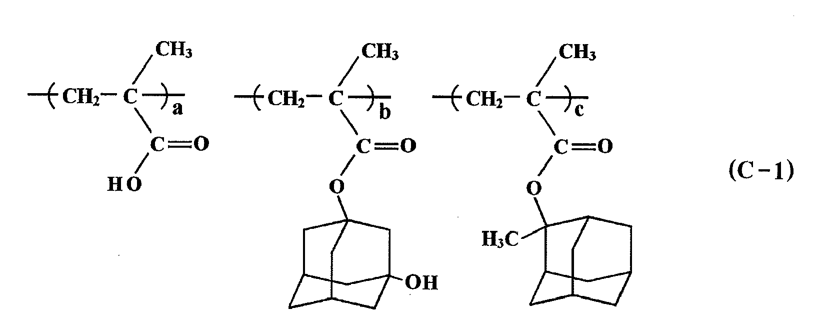

Polymer (C-1) Copolymerization ratio: a/b/c = 11.4/38.5/50.1, Mw/Mn = 1.93, Mw = 6900, amount of remaining low molecular weight components (wt%) = 0.12

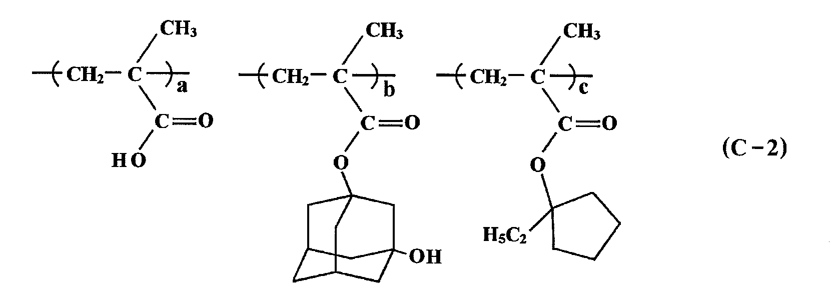

Polymer (C-2) Copolymerization ratio: a/b/c = 13.5/42.5/44.0, Mw/Mn = 1.90, Mw = 8700, amount of remaining low molecular weight components (wt%) = 0.13 Examples 1 to 16 and Comparative Examples 1 to 3

Radiation-sensitive resin composition solutions were prepared by using the polymers (A-1) to (A-6), polymers (B-1) to (B-6), polymer (C-1), and polymer (C-2), the following acid generators, and other components in the proportions shown in Table 1. The resulting radiation-sensitive resin composition solutions were exposed to radiation using the liquid for liquid immersion lithography shown in Table 1 to evaluate various items. The film-forming conditions and evaluation results are shown in Table 2. In the examples, "part" refers to "part by weight" unless otherwise indicated.

The refractive index of the liquids used for liquid immersion lithography at a wavelength of 193 nm was 1.63 (trans-decalin), 1.65 (exo-tricyclo[3.2.1.0^{2,6}])decane, and 1.57 (n-hexadecane). A goniometer-spectrometer I UV-VIS-IR manufactured by MOLLER-WEDEL was used as the refractive index measurement instrument. The refractive index was measured using the minimum deviation angle method at a temperature of 25°C.

### Acid generator (D)

(D-1): 1-(4-n-butoxynaphthyl)tetrahydrothiophenium nonafluoro-n-butanesulfonate
(D-2): triphenylsulfonium·nonafluoro-n-butanesulfonate
(D-3): triphenylsulfonium 2-bicyclo[2.2.1]hept-2-yl-1,1,2,2-tetrafluoroethanesulfonate
(D-4): triphenylsulfonium 2-bicyclo[2.2.1]hept-2-yl-1,1-difluoroethanesulfonate

### Acid diffusion controller (E)

(E-1): (R)-(+)-1-(t-butoxycarbonyl)-2-pyrrolidinemethanol

### Solvent (F)

(F-1): propylene glycol monoethyl ether acetate
(F-2): γ-butyrolactone

### Evaluation method

### (1) Pattern formation A

After forming a coating with a thickness of 40 nm (after baking at 205°C for 60 seconds) using an underlayer reflection preventing film "ARC29A" (manufactured by Brewer Science, Inc.) on an eight-inch silicon wafer by spin coating using "CLEAN TRACK Mark8" (manufactured by Tokyo Electron, Ltd.), a coating with a thickness of 60 nm or 80 nm was formed from the resist composition of the Table by spin coating and baking (under the conditions shown in Table 2) using "CLEAN TRACK Mark8" (manufactured by Tokyo Electron, Ltd.). Using an ArF excimer laser dual beam interference aligner (manufactured by Canon Inc.), the coating was exposed to light via a prism for 32 nm line-and-space (1L1S) patterns by adding the liquid for liquid immersion lithography shown in Table 1 between the lens and the resist using a pipette. After PEB under the conditions shown in Table 2, the resist pattern was developed at 23°C for 60 seconds in a 2.38 wt% tetramethylammonium hydroxide aqueous solution, washed with water, and dried to form a positive-tone resist pattern. An optimum dose at which a line-and-space (1L1S) pattern with a line width of 32 nm was formed was taken as sensitivity. A scanning electron microscope ("S-9380" manufactured by Hitachi High-Technologies Corporation) was used for the measurement. The cross-sectional form of a 32 nm line-and-space pattern was observed by "S-4800" manufactured by Hitachi High-Technologies Corporation. The results of the 32 nm line-and-space pattern profile are shown in Table 2. When the 32 nm line-and-space pattern was successfully produced, the composition was indicated as "Good", otherwise as "Bad". A composition not evaluated was indicated as "-".

### (2) Pattern formation B

A test sample was prepared using the same method as the method of the pattern formation A. Pattern formation was confirmed when using the sample of Comparative Example 3 by replacing the material between the lens and resist with water. The results are shown in Table 2.

### (3) Measurement of amount of elution

A 30 × 30 cm square silicon rubber sheet with a thickness of 1.0 mm (manufactured by Kureha Elastomer Co., Ltd.) of which the center was hollowed in a circle with a diameter of 11.3 cm was placed on the center of an eight-inch silicon wafer which was previously treated with HMDS (100°C for 60 seconds) using "CLEAN TRACK ACT 8" (manufactured by Tokyo Electron, Ltd.). The circular area of the center of the silicone rubber sheet, from which a disk has been removed, was filled with 10 ml of ultra-pure water using a 10 ml one-mark pipette.

After forming a coating with a thickness of 77 nm (after baking at 205°C for 60 seconds) using an underlayer reflection preventing film "ARC29A" (manufactured by Brewer Science, Inc.) on an eight-inch silicon wafer by spin coating using "CLEAN TRACK ACT8" (manufactured by Tokyo Electron, Ltd.), the resist composition shown in Table 3 was spin-coated, followed by further spin coating of trans-decalin or ultra-pure water in order to measure a relative elution level, using "CLEAN TRACK ACT8" (manufactured by Tokyo Electron, Ltd.). A resist composition sample without spin-coating any material was also prepared as a reference. The samples were baked at 115°C for 60 seconds to obtain resist films with a thickness of 205 nm. The formed wafer was put on the previously-formed wafer so that the resist-coated surface was able to come in contact with the ultra-pure water and the ultra-pure water did not leak from the silicon rubber for ten seconds as counted by a stopwatch, following which the silicon wafer was removed. After the experiment, the ultra-pure water was collected using a glass injector for use as a sample for analysis. The recovery rate of the ultra-pure water upon completion of the experiment was 95% or more.

The peak intensity of the anion moiety of the photoacid generator in the ultra-pure water obtained by the above experiment was measured by liquid chromatography mass spectrometry (LC-MS) (LC section: "SERIES 1100" manufactured by AGILENT, MS section: "Mariner" manufactured by Perseptive Biosystems, Inc.) using a column ("CAPCELL PAK MG" manufactured by Shiseido Co., Ltd.) at a flow rate of 0.2 ml/min, and using a solution of 0.1 wt% formic acid in a 3:7 mixture of water and methanol as an eluant at 35°C. In this instance, peak intensities of the aqueous solutions of triphenylsulfonium nonafluoro-n-butane sulfonate at concentrations of 1 ppb, 10 ppb, and 100 ppb were measured under the above conditions to prepare a calibration curve. The eluted amount was calculated from the above peak intensity using this calibration curve. The peak intensities of aqueous solutions of the acid diffusion controller at concentrations of 1 ppb, 10 ppb, and 100 ppb were measured under the same conditions to prepare a calibration curve. The eluted amount was calculated from the above peak intensity using this calibration curve.

The results of elution amount measurement are shown in Table 3. As a result, using the amount of elution from the sample with no coating after the resist composition coating as a reference, a sample of which the amount of elution was exponentially the same digit as the amount of elution of the reference was evaluated as "no elution" and a sample of which the amount of elution was exponentially the lower digit as the amount of elution of the reference was evaluated as "eluted".

**[Table 1]**

| | Polymer (part) | | Acid generator (part) | | Acid diffusion controller (part) | | Solvent (part) | | Liquid for liquid immersion lithography |
|---|---|---|---|---|---|---|---|---|---|
| Example | | | | | | | | | |
| 1 | A-1 | 100 | D-1/D-2 | 6/1 | E-1 | 0.3 | F-1/F-2 | 1430/70 | trans-Decalin |
| 2 | A-2 | 100 | D-1/D-2 | 6/1 | E-1 | 0.3 | F-1/F-2 | 1430/70 | trans-Decalin |
| 3 | A-3 | 100 | D-1/D-2 | 6/1 | E-1 | 0.3 | F-1/F-2 | 1430/70 | trans-Decalin |
| 4 | A-4 | 100 | D-1/D-2 | 6/1 | E-1 | 0.3 | F-1/F-2 | 1430/70 | trans-Decalin |
| 5 | A-5 | 100 | D-1/D-2 | 6/1 | E-1 | 0.3 | F-1/F-2 | 1430/70 | trans-Decalin |
| 6 | A-6 | 100 | D-1/D-2 | 6/1 | E-1 | 0.3 | F-1/F-2 | 1430/70 | trans-Decalin |
| 7 | B-1 | 100 | D-1/D-2 | 6/1 | E-1 | 0.3 | F-1/F-2 | 1430/70 | trans-Decalin |
| 8 | B-2 | 100 | D-1/D-2 | 6/1 | E-1 | 0.3 | F-1/F-2 | 1430/70 | trans-Decalin |
| 9 | B-3 | 100 | D-1/D-2 | 6/1 | E-1 | 0.3 | F-1/F-2 | 1430/70 | trans-Decalin |
| 10 | B-4 | 100 | D-1/D-2 | 6/1 | E-1 | 0.3 | F-1/F-2 | 1430/70 | trans-Decalin |
| 11 | B-5 | 100 | D-1/D-2 | 6/1 | E-1 | 0.3 | F-1/F-2 | 1430/70 | trans-Decalin |
| 12 | B-6 | 100 | D-1/D-2 | 6/1 | E-1 | 0.3 | F-1/F-2 | 1430/70 | trans-Decalin |
| | | | | | | | | | exo-Tricyclo |
| 13 | A-1 | 100 | D-1/D-2 | 6/1 | E-1 | 0.3 | F-1/F-2 | 1430/70 | [3.2.1.0^{2. 6}] |
| | | | | | | | | | decane |
| 14 | A-1 | 100 | D-1/D-2 | 6/1 | E-1 | 0.3 | F-1/F-2 | 1430/70 | n-Hexadecane |
| 15 | A-1 | 100 | D-1/D-3 | 5/2 | E-1 | 0.3 | F-1/F-2 | 1430/70 | trans-Decalin |
| 16 | A-1 | 100 | D-1/D-4 | 5/2 | E-1 | 0.3 | F-1/F-2 | 1430/70 | trans-Decalin |

| Comparative Example | | | | | | | | | |
|---|---|---|---|---|---|---|---|---|---|
| 1 | C-1 | 100 | D-1/D-2 | 6/1 | E-1 | 0.3 | F-1/F-2 | 1430/70 | trans-Decalin |
| 2 | C-2 | 100 | D-1/D-2 | 6/1 | E-1 | 0.3 | F-1/F-2 | 1430/70 | trans-Decalin |
| 3 | A-1 | 100 | D-1/D-2 | 6/1 | E-1 | 0.3 | F-1/F-2 | 1430/70 | Water |

**[Table 2]**

| | Bake temperature/time | PEB temperature/time | Sensitivity | 32 nm LS Pattern formation /thickness 60 nm | 32 nm LS Pattern formation /thickness 80 nm |
|---|---|---|---|---|---|
| Example | | | | | |
| 1 | 115°C/60s | 115°C/60s | 17mJ/cm2 | Good | Good |
| 2 | 120°C/60s | 115°C/60s | 20mJ/cm2 | Good | Good |
| 3 | 120°C/60s | 130°C/60s | 17mJ/cm2 | Good | - |
| 4 | 100°C/60s | 110°C/60s | 15mJ/cm2 | Good | Good |
| 5 | 115°C/60s | 115°C/60s | 10mJ/cm2 | Good | Good |
| 6 | 115°C/90s | 105°C/90s | 12mJ/cm2 | Good | - |
| 7 | 115°C/60s | 120°C/60s | 15mJ/cm2 | Good | - |
| 8 | 120°C/60s | 120°C/60s | 17mJ/cm2 | Good | - |
| 9 | 120°C/60s | 120°C/60s | 10mJ/cm2 | Good | Good |
| 10 | 120°C/60s | 120°C/60s | 20mJ/cm2 | Good | - |
| 11 | 120°C/60s | 110°C/60s | 11mJ/cm2 | Good | - |
| 12 | 120°C/60s | 110°C/60s | 12mJ/cm2 | Good | - |
| 13 | 115°C/60s | 115°C/60s | 17mJ/cm2 | Good | Good |
| 14 | 115°C/60s | 115°C/60s | 17mJ/cm2 | Good | Good |
| 15 | 115°C/60s | 115°C/60s | 19mJ/cm2 | Good | - |
| 16 | 115°C/60s | 115°C/60s | 19mJ/cm2 | Good | - |

| Comparative Example | | | | | |
|---|---|---|---|---|---|
| 1 | 100°C/60s | 110°C/60s | Unmeasureble | Bad | - |
| 2 | 100°C/60s | 110°C/60s | Unmeasureble | Bad | - |
| 3 | 115°C/60s | 115°C/60s | Unmeasureble | Bad | - |

| | | | | | |
|---|---|---|---|---|---|
| - : Unevaluated | | | | | |

**[Table 3]**

| | Material coated after resist coating | Bake temperature /time | Elution amount of acid generator (mol/cm²) | | | |
|---|---|---|---|---|---|---|
| | | | Cation moiety | | Anion moiety | |
| | | | Measured value | Evaluation | Measured value | Evaluation |
| Example | | | | | | |
| 1 | trans-Decalin | 115°C/60s | 2.5E-11 | No elution | 1.7E-11 | No elution |
| 15 | trans-Decalin | 115°C/60s | 2.3E-11 | No elution | 1.6E-11 | No elution |
| 1 | None | 115°C/60s | 2.7E-11 | Reference | 2.4E-11 | Reference |

| Comparative Example | | | | | | |
|---|---|---|---|---|---|---|
| 3 | Water | 115°C/60s | 2.7E-12 | Eluted | 2.1E-12 | Eluted |

### INDUSTRIAL APPLICABILITY

The radiation-sensitive resin composition of the present invention can produce an excellent pattern profile and exhibits excellent resolution and focal depth allowance in liquid immersion lithography in which a liquid having a high index of refraction is used, while being eluted in the liquid only to the minimal amount. Therefore, the composition can be extremely suitably used for manufacturing integrated circuit devices, which are expected to become more and more minute.

## Claims

1. A radiation-sensitive resin composition for forming a photoresist film used in liquid immersion lithography, in which radiation is emitted through a liquid for use in the liquid immersion lithography having a refractive index of more than 1.44 and less than 1.85 at a wavelength of 193 nm, existing between a lens and the photoresist, the composition comprising a resin having a recurring unit with a lactone structure and being insoluble or scarcely soluble in alkali, but becoming readily soluble in alkali by the action of an acid; and a radiation-sensitive acid generator.

2. The radiation-sensitive resin composition according to claim 1, wherein the resin having the recurring unit with the lactone structure is a copolymer which further has a recurring unit shown by the following formula (1), 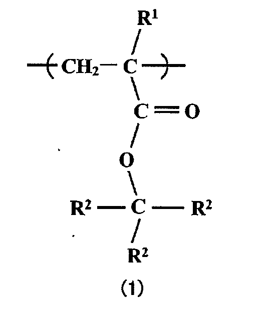 wherein R¹ represents a hydrogen atom, a methyl group, or a trifluoromethyl group, R² individually represents a monovalent alicyclic hydrocarbon group having 4 to 20 carbon atoms, a derivative thereof, or a linear or branched alkyl group having 1 to 4 carbon atoms, provided that at least one of the R²s is the alicyclic hydrocarbon group or a derivative thereof, or two of the R²s bond together to form a divalent alicyclic hydrocarbon group having 4 to 20 carbon atoms or a derivative thereof, with the remaining R² being a linear or branched alkyl group having 1 to 4 carbon atoms, a monovalent alicyclic hydrocarbon group having 4 to 20 carbon atoms, or a derivative thereof.

3. The radiation-sensitive resin composition according to claim 2, wherein the content of low molecular weight components containing monomers as the major component in the copolymer is not more than 0.1 wt%, on a solid basis, of the total amount of the copolymer.

4. The radiation-sensitive resin composition according to claim 2, wherein the content of the recurring unit with the lactone structure is 5 to 85 wt% of the total amount of the copolymer.

5. The radiation-sensitive resin composition according to claim 2, wherein the recurring unit shown by the formula (1) has an alicyclic hydrocarbon structure.

6. The radiation-sensitive resin composition according to claim 1, wherein the liquid used for liquid immersion lithography is at least one compound selected from a group consisting of alicyclic hydrocarbon compounds and chain-like saturated hydrocarbon compounds.

7. The radiation sensitive resin composition according to claim 1, wherein the radiation-sensitive acid generator is a compound shown by the following formula (8), 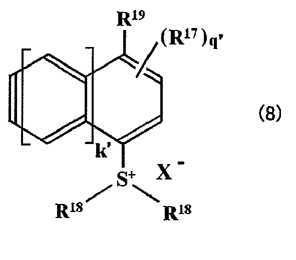 wherein R¹⁹ individually represents a hydrogen atom, a fluorine atom, a hydroxyl group, a linear or branched alkyl group having 1 to 10 carbon atoms, a linear or branched alkoxyl group having 1 to 10 carbon atoms, or a linear or branched alkoxycarbonyl group having 2 to 11 carbon atoms, R¹⁷ represents a linear or branched alkyl group having 1 to 10 carbon atoms, a linear or branched alkoxyl group having 1 to 10 carbon atoms, or a linear, branched, or cyclic alkanesulfonyl group having 1 to 10 carbon atoms, R¹⁸ individually represents a linear or branched alkyl group having 1 to 10 carbon atoms, a phenyl group or naphtyl group which may have a substituent, or two R¹⁸s bond together to form a substituted or unsubstituted divalent group having 2 to 10 carbon atoms, k' is an integer of 0 to 2, X⁻ indicates an anion of the formula R²⁰CₙF₂ₙSO₃⁻ (wherein R²⁰ is a fluorine atom or a substituted or unsubstituted hydrocarbon group having 1 to 12 carbon atoms, and n is an integer of 1 to 10), and q' is an integer of 0 to 10.
